# EUROPÄISCHE PATENTSCHRIFT

(11) **EP 1 695 037 B1**
(45) Veröffentlichungstag und Bekanntmachung des Hinweises auf die Patenterteilung: **09.11.2016**
(21) Anmeldenummer: 04803567.9
(22) Anmeldetag: 06.12.2004
(51) Int. Cl.: G01D 11/24, B29C 70/72, B29C 70/84, H03K 17/945, H03K 17/95

(54) **VERFAHREN ZUR HERSTELLUNG EINES SCHALTGERÄTS SOWIE BAUGRUPPE FÜR EIN SCHALTGERÄT**
METHOD FOR THE PRODUCTION OF A SWITCHING DEVICE, AND SUBASSEMBLY FOR A SWITCHING DEVICE
PROCEDE POUR PRODUIRE UN APPAREIL DE COMMUTATION, ET COMPOSANT POUR CET APPAREIL DE COMMUTATION

(30) Priorität: 19.12.2003 DE 10359885
(43) Veröffentlichungstag der Anmeldung: 30.08.2006
(73) Patentinhaber: Pepperl + Fuchs GmbH, 68307 Mannheim (DE)
(72) Erfinder: SCHOEN, Dierk, 63329 Egelsbach (DE); DIVARIS, Dionysios, 64347 Griesheim (DE)
(74) Vertreter: Schiffer, Axel Martin
(86) Internationale Anmeldenummer: PCT/EP2004/013874
(87) Internationale Veröffentlichungsnummer: WO 2005/064278

(56) Entgegenhaltungen:
- WO-A2-2005/090924
- DE-A1- 19 808 153
- DE-U1- 8 805 837
- FR-A- 2 620 222
- US-A- 6 025 562
- US-B1- 6 617 845

## Beschreibung

Die Erfindung betrifft in einem ersten Aspekt ein Verfahren zur Herstellung eines Schaltgeräts nach dem Oberbegriff des Anspruchs 1. In einem weiteren Aspekt bezieht sich die Erfindung auf eine Baugruppe für ein Schaltgerät.

Ein gattungsgemäßes Verfahren zur Herstellung eines Schaltgeräts mit einer Sensoreinheit, die an einem Messende einer Gehäusehülse angeordnet und mit einer elektronischen Schaltung verbunden ist, die auf einem in der Gehäusehülse aufgenommenen Träger angeordnet ist, und mit einem an einem Hinterende der Gehäusehülse angeordneten Anschlussteil, ist in DE 100 13 218 C2 beschrieben. Das Schaltgerät wird dort zwar in einem einzügigen Verfahren montiert, wobei aber zur exakten Positionierung ein separates Zentrierstück benötigt wird, das vor dem Aushärten eines in das Gehäuse eingebrachten Vergusses separat einzuführen ist, um das Messende mit dem Sensor präzise auszurichten.

Ein Schaltgerät der genannten Art, bei dem der Erfassungsbereich eines Sensors winklig zur Längsachse verläuft, ist in DE 201 06 871 U1 beschrieben.

Ein weiteres einzügiges Montageverfahren ist Gegenstand von DE 195 04 608 C2. Auch dort wird zur Ausrichtung des Messendes ein separates, in die Gehäusehülse einzubringendes Zentrierstück benötigt.

Weitere Verfahren, die sich aber jeweils nicht in einem Zug durchführen lassen und somit vergleichsweise aufwändig sind, sind in DE 195 44 815 C1 sowie DE 101 53 489 A1 offenbart.

Ein Verfahren zur Herstellung eines Näherungsschalters mit Befestigungshülse ist in DE 40 23 792 C2 beschrieben. Dabei sind auf einer Platine gehaltene Bauteile einschließlich eines Sensors in Kunststoff eingebettet, wobei zunächst der Sensor mit der Platine in Verbindung gebracht wird und dann der Sensor in einem Topf eingegossen wird. Um eine Kunststoffeinbettung ohne Unterbrechung des Fertigungstakts zu ermöglichen, wird vorgeschlagen, dass darauf folgend der Topf, die Platine und ein daran angeschlossenes Kabel gemeinsam in einer Gießform zu einer Einheit vergossen werden, die schließlich in die Befestigungshülse eingeschoben wird.

DE 295 22 086 U1 bezieht sich auf ein elektrisches oder elektronisches Gerät, insbesondere einen Näherungsschalter. Um eine einfachere Herstellung zu ermöglichen, wird dabei vorgeschlagen, ein Gehäuse zu verwenden, welches im Druckguss hergestellt ist.

Weitere Näherungsschalter und Verfahren zu deren Herstellung sind in US-6,025,562, DE 198 08 153 A1 sowie DE 92 10 480.0 U1 beschrieben.

Die Schrift WO 2005/090924 A2, die nach Art. 54 (3) EPÜ zum Stand der Technik zählt, betrifft ein Einbausystem für elektronische Schaltkreise. Dabei wird ein elektronischer Schaltkreis auf ein Substrat aufgebracht und in ein Gehäuse eingesetzt. Anschließend wird das Gehäuse in eine äußere Hülle aufgenommen, wobei zwischen Gehäuse und Hülle ein isolierendes Medium gefüllt wird.

**Aufgabe** der vorliegenden Erfindung ist es, ein Verfahren zur Herstellung eines Schaltgeräts anzugeben, das besonders einfach durchzuführen ist. Weiterhin soll eine Baugruppe für ein Schaltgerät geschaffen werden.

Diese Aufgabe wird in einem ersten Aspekt der Erfindung durch das Verfahren mit den Merkmalen des Anspruchs 1 gelöst.

In einem zweiten erfindungsgemäßen Aspekt wird die Aufgabe durch die Baugruppe mit den Merkmalen des Anspruchs 23 gelöst.

Vorteilhafte Varianten des erfindungsgemäßen Verfahrens und bevorzugte Ausgestaltungen der erfindungsgemäßen Baugruppe sind Gegenstand der abhängigen Ansprüche.

Das Verfahren der oben genannten Art ist erfindungsgemäß dadurch gebildet, dass die Sensoreinheit, der Träger und das Anschlussteil zusammen mit einer den Träger umschließenden Schirmhülse zu einer formstabilen Baugruppe zusammengesetzt werden und dass die Baugruppe anschließend in die Gehäusehülse eingeführt und dort fixierend aufgenommen wird.

Die erfindungsgemäße Baugruppe für ein Schaltgerät zum Einbau in eine Gehäusehülse weist folgende Komponenten auf: eine Sensoreinheit mit einem Sensor zum Nachweis eines Messsignals, eine auf einem Träger angeordnete elektronische Schaltung, wobei der Träger an mindestens einem Ende, in vorteilhafter Ausgestaltung an einem Messende, mit der Sensoreinheit formstabil verbunden ist und wobei die Schaltung mit der Sensoreinheit elektrisch verbunden ist, eine den Träger, insbesondere koaxial, umschließende Schirmhülse, die mit der Sensoreinheit und mit dem Träger formstabil verbunden ist, und ein, insbesondere ebenfalls koaxial zu den zuvor benannten Komponenten angeordnetes Anschlussteil für den Anschluss der Schaltung an externe Geräte und/oder Anschlüsse, das auf den Träger und/oder auf die Schirmhülse aufgesetzt ist.

Als ein Kerngedanke der Erfindung kann angesehen werden, zunächst aus der Sensoreinheit, dem Träger und dem Anschlussteil zusammen mit einer den Träger umgebenden Schirmhülse, eine Baugruppe zu bilden, die anschließend in ein Gehäuse eingebracht wird. Eine weitere Kernidee besteht in diesem Zusammenhang darin, die verwendeten Komponenten so auszubilden, dass bei der Montage, bei der es sich im einfachsten Fall um ein simples Zusammenstecken handelt, praktisch automatisch die richtige relative Positionierung der Komponenten zueinander ergibt.

Gemäß einem weiteren Kerngedanken sind die genannten Bauteile außerdem so geformt und ausgebildet, dass die Baugruppe beim Einführen in das Gehäuse dort fixierend aufgenommen wird.

Hierdurch kann als wesentlicher Vorteil des erfindungsgemäßen Verfahrens erreicht werden, dass nach dem Einführen der Baugruppe in die Gehäusehülse keine weiteren Maßnahmen zur Zentrierung und zur Ausrichtung der Komponenten mehr erforderlich ist. Da das Verfahren dann im Wesentlichen einzügig ist, kann es sehr kostengünstig durchgeführt werden. Gleichwohl können hochpräzise Schaltgeräte hergestellt werden. Insgesamt können Fertigungssicherheit und Fertigungseffizienz erhöht werden.

Bei einer besonders bevorzugten Variante des Verfahrens wird die Baugruppe von dem Messende her in die Gehäusehülse eingeführt. Auf diese Weise kann in Verbindung mit der bereits in präziser Ausrichtung zusammengebauten Baugruppe, die auch als Zwischenbaugruppe bezeichnet werden kann, eine besonders präzise Orientierung der Komponenten zueinander erzielt werden.

Grundsätzlich ist es aber auch möglich, die Baugruppe von dem Hinterende der Gehäusehülse her in die Gehäusehülse einzuführen. Das Verfahren ist also besonders vielseitig durchführbar. Insbesondere kann das Verfahren unabhängig von einer eventuellen Orientierung der Sensoreinheit durchgeführt werden.

Es können also sowohl axial ausgerichtete als auch gewinkelte Wandler oder Schaltgeräte mit dem erfindungsgemäßen Verfahren hergestellt werden.

Besonders robuste Schaltgeräte können in einfacher Weise hergestellt werden, wenn die Baugruppe dichtend in die Gehäusehülse eingeführt wird. Zweckmäßig sind hierfür an der Baugruppe und/oder an der Gehäusehülse geeignete Dichteinrichtungen, wie beispielsweise Dichtlippen, und/oder Wülste und entsprechende Nuten und/oder Dichtungen mit separaten Dichtungselementen, und/oder in vorteilhafter Ausgestaltung bei ausreichendem Durchmesser der Gehäusehülse O-Ringe, vorgesehen. Ein auf diese Weise hergestelltes Schaltgerät ist besonders vielseitig einsetzbar, insbesondere auch in Umgebungen, wo Feuchte und/oder aggressive Fluide auf das Schaltgerät einwirken, beispielsweise in Werkzeugmaschinen.

Besonders einfach gestaltet sich das Herstellen der erfindungsgemäßen Baugruppe und das erfindungsgemäße Herstellungsverfahren, wenn eine zylindrische Schirmhülse und eine zylindrische Gehäusehülse verwendet werden. Diese Komponenten sind selbst kostengünstig herstellbar oder gegebenenfalls zuzukaufen. Die Schirmhülse wird dabei zweckmäßig mit dem Träger und/oder mit der elektronischen Schaltung auf dem Träger elektrisch kontaktiert. Diese elektrische Kontaktierung kann insbesondere so ausgeführt sein, dass dadurch außerdem eine mechanische Stabilisierung erzielt wird. Zweckmäßig kann die Schirmhülse hierfür eine oder mehrere Kontaktlaschen an beliebiger Stelle am Umfang der Schirmhülse aufweisen.

Als Träger wird bevorzugt eine Leiterplatte verwendet, die in ausgerichteten Eingriff mit der Sensoreinheit gebracht wird. Die Leiterplatte wird anschließend mit der Sensoreinheit elektrisch verbunden. Mit einfachen Maßnahmen wird somit bereits eine definierte Orientierung der Komponenten zueinander erzielt. Auch hier kann die elektrische Kontaktierung zwischen Leiterplatte und Sensoreinheit zusätzlich eine mechanische Stabilisierung bereitstellen. Eine definierte Ausrichtung der Komponenten zueinander wird außerdem bevorzugt dadurch erreicht, dass.die Schirmung definiert, den Träger umgebend, mit der selbstzentrienden zylindrischen Sensoreinheit in Anschlag gebracht wird.

In diesem Zusammenhang ist es außerdem zweckmäßig, wenn das Anschlussteil in definierter Ausrichtung mit dem Träger auf einen endseitigen Bereich der Schirmhülse aufgebracht wird.

Die Stabilität, die Resistenz gegen äußere Einflüsse, wie beispielsweise Feuchte und/oder aggressive Fluide, und die elektrische Sicherheit des Schaltgeräts wird außerdem erhöht, wenn die Bereiche zwischen Träger und Schirmhülse und/oder zwischen Schirmhülse und Gehäusehülse vergossen und/oder ausgespritzt werden.

Ein solcher Verguss kann in besonders einfacher Weise durch Öffnungen in dem Anschlussteil durchgeführt werden.

Grundsätzlich erfolgt dieses Vergießen nach dem Zusammenbau des Schaltgeräts. Um eine Blasenbildung im Bereich eines transparenten Anschlussteils und eine damit zusammenhängende Beeinträchtigung der optischen Eigenschaften durch zusätzliche Grenzflächen beim Vergießen zu vermeiden, kann es zweckmäßig sein, bei der Baugruppe in dem Anschlussteil einen Vorverguss mit einem nach Aushärtung transparenten und/oder mit einem semitransparenten Material durchzuführen.

Eine höhere elektrische Schutzklasse kann erzielt werden, wenn ein Anschlussteil mit einem langgestreckten Kragen verwendet wird, der über die Schirmhülse geschoben und mit der Sensoreinheit in Anschlag gebracht wird. Dieser Kragen füllt bevorzugt den Raum zwischen Schirmhülse und Gehäusehülse praktisch vollständig aus. Ein Vergießen dieses Bereichs ist dann nicht mehr nötig und auch die damit zusammenhängenden Urizuverlässigkeiten können vermieden werden. Mit einem so hergestellten Schaltgerät kann außerdem die Isolationsschutzklasse 2 erreicht werden.

Bei Sensoren, bei denen die Notwendigkeit einer geeigneten Abschirmung der Sensoreinheit gegenüber störender elektromagnetischer Strahlung begründet ist, wird die Abschirmung, bevor sie mit der Schaltung auf der Leiterplatte verbunden wird, in eine zentrierende, becherartige Schirmbuchse eingesetzt. Ansonsten wird ein ähnliches Bauelement zur Zentrierung der Schirmhülse verwendet.

An dieser Schirmbuchse können zweckmäßig Kontaktlaschen vorgesehen sein, die mit der Leiterplatte verlötet werden. Durch diese Kontaktlaschen kann wiederum eine mechanische Stabilisierung erzielt werden.

Bei dem Sensor kann es sich z.B. um einen induktiven, optischen, kapazitiven, Temperatur-, Druck- und/oder Gassensor handeln. Insbesondere kann das Schaltgerät ein Näherungsschalter sein.

Weitere Vorteile und Eigenschaften des erfindungsgemäßen Verfahrens und der erfindungsgemäßen Baugruppe werden nachstehend unter Bezugnahme auf die beigefügten schematischen Figuren beschrieben.

Dort zeigen:
- Fig. 1: eine schematische, explosionsartige Darstellung der erfindungsgemäßen Baugruppe zusammen mit einer Gehäusehülse;
- Fig. 2 und 3: in Längsschnittansichten ein Ausführungsbeispiel eines erfindungsgemäß hergestellten Schaltgeräts entsprechend einzügiger Montage vom Messende her mit einem Anschlussteil in einer Version für Kabel;
- Fig. 4: eine Schnittansicht entlang der Linie A - A in Figur 2;
- Fig.: 5 eine Schnittansicht entlang der Linie B - B in Figur 3;
- Fig. 6: ein Detail einer Leiterplatte in einem erfindungsgemäß hergestellten Schaltgerät;
- Fig. 7: in einer Schnittansicht ein zweites Beispiel eines nach dem erfindungsgemäßen Verfahren hergestellten Schaltgeräts entsprechend einzügiger Montage vom Messende her mit einem Anschlussteil in der Version für Stecker, wobei in Fig. 7A der Ausschnitt A vergrößert dargestellt ist;
- Fig. 8: ein Detail des in Fig. 7 gezeigten Ausführungsbeispiels;
- Fig. 9: ein Detail eines Steckereinsatzes für eine erfindungsgemäße Baugruppe;
- Fig. 10: ein Detail des in Fig. 9 gezeigten Steckereinsatzes;
- Figuren 11 u. 12: Details eines erfindungsgemäß hergestellten Schaltgeräts im Bereich der Verbindung von Gehäusehülse und Anschlussteil;
- Fig. 13: weitere Details ähnlich dem in Fig. 8 gezeigten Ausführungsbeispiel;

- Fig. 14: in einer Teilansicht eine Variante eines Anschlussteils;
- Fig. 15: in einer Schnittansicht ein Beispiel eines Schaltgerätes entsprechend einer Montage von der Anschlussseite her mit einem Anschlussteil in der Version für Stecker und mit einer O-Ring-Variante, und
- Fig. 16: Details eines erfindungsgemäß hergestellten Schaltgeräts im Bereich der Verbindung von Gehäusehülse und Sensoreinheit.

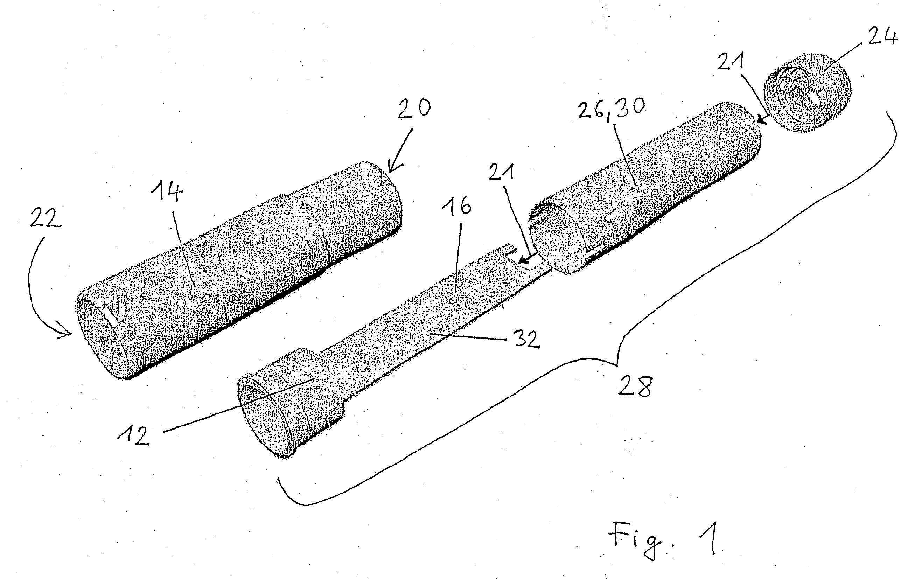

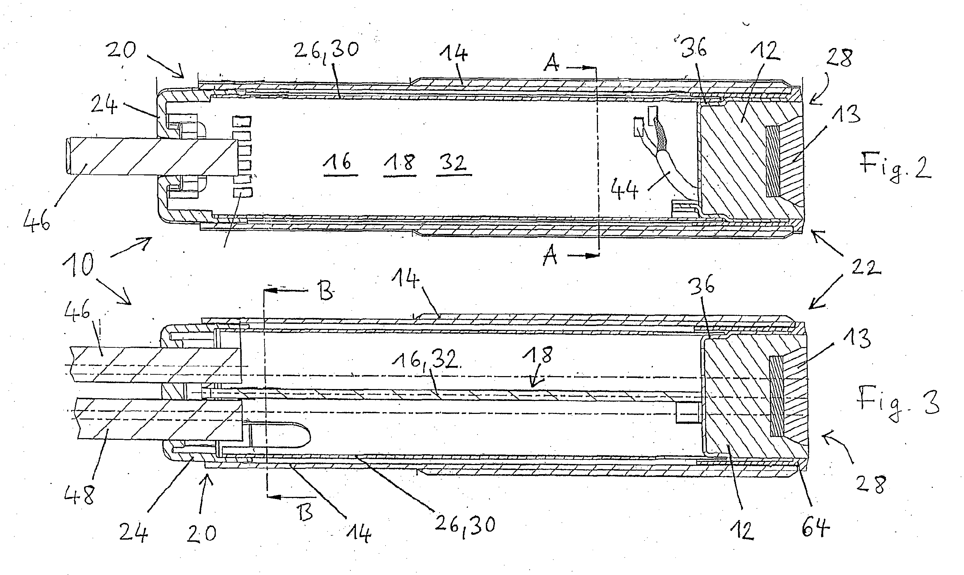

Das erfindungsgemäße Verfahren wird unter Bezugnahme auf Figur 1 erläutert, in der eine Baugruppe 28, die auch als Zwischenbaugruppe bezeichnet werden kann, explosionsartig zusammen mit einer Gehäusehülse 14 dargestellt ist. Die Baugruppe 28 wird zusammengesetzt aus einer Sensoreinheit 12, einem als Leiterplatte 32 ausgebildeten Träger 16 für eine elektronische Schaltung, einer als Schirmhülse 30 ausgebildeten Schirmung 26 und einem Anschlussteil 24. Diese Komponenten werden in der in Figur 1 durch Pfeile 21 dargestellten Richtung zusammengeschoben und auf diese Weise zur fertigen Baugruppe 28 zusammengesetzt. Anschließend wird diese Baugruppe 28 von einem Messende 22 der Gehäusehülse 14 in diese eingesetzt, wie es auch in den Beispielen nach Figur 2, 3 oder 7, 8 realisiert ist.

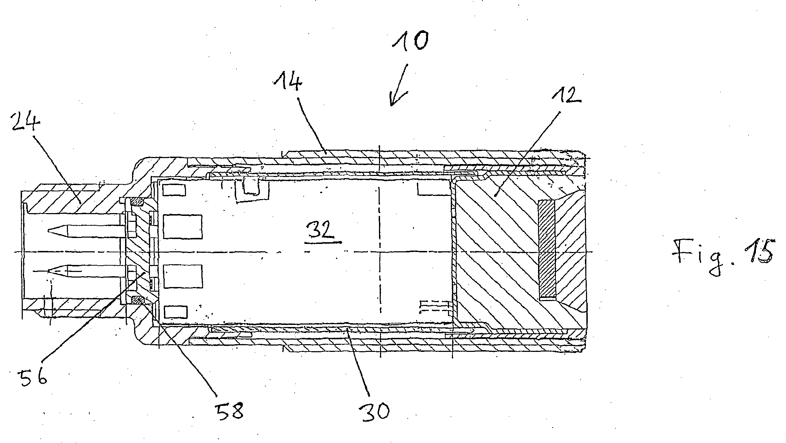

Prinzipiell kann die Gehäusehülse 14, die Sensoreinheit 12 und/oder das Anschlussteil 24 auch so geformt sein, dass die Baugruppe 28 von einem Hinterende 20 der Gehäusehülse 14 in diese eingebracht wird. Die Gehäusehülse 14 kann aus Metall und/öder Kunststoff bestehen, wie es auch in dem Beispiel nach Figur 15 realisiert ist.

Das erfindungsgemäße Verfahren ermöglicht also eine einzügige Montage einer kompletten, praktisch völlig rotationssymmetrischen geschirmten fertigen, in den Grundelementen koaxial aufgebauten Baugruppe 28 in ein längs gestrecktes zylindrisches Gehäuse. Auf diese Weise entfallen im Vergleich zum Stand der Technik gleich mehrere bisher notwendige Montageschritte.

In dem in Figur 1 gezeigten Beispiel haben die Sensoreinheit und das Anschlussteil 24, das als voll transparenter und/oder semitransparenter Endabschluss oder Steckereinsatz ausgebildet sein kann, eine die Leiterplatte und/oder die Schirmung zentrierende Funktion. Die längs gestreckte zylindrische Schirmhülse 30 ist so angebracht, dass zur Leiterplatte 32 und zur der anschließend darüber geführten Gehäusehülse 14 jeweils ein ausreichender Isolationsabstand gewährleistet ist, um die üblichen Normen der Näherungsschaltertechnik, beispielsweise EN 60947, einzuhalten. Das Anschlussteil 24 zentriert in Verbindung mit der Wandleraufnahme 64 die Baugruppe 28 in der zylindrischen Gehäusehülse 14 selbsttätig.

Das Fertigungsverfahren eignet sich für verschiedene Ausführungen der Sensoreinheiten 12, die auch als Wandleraufnahmen 64 bezeichnet werden können, am Messende. Insbesondere können gerade und gewinkelte Wandleraufnahmen verwendet werden, in die jeweils, unabhängig vom Messprinzip, beliebige Messwandler eingesetzt werden können. Auch im Hinblick auf das Anschlussteil 24 bestehen denkbar große Variationsmöglichkeiten. Es können verschiedene Anschlussteile 24, die auch als Abschlussteile und/oder Abschlusskappe und/oder transparenter Endabschluss bezeichnet werden können, verwendet werden. Insbesondere sind Anschlussteile mit Kabelabgang oder Steckerabgang möglich, ohne dass dies das erfindungsgemäße Fertigungsprinzip, das im Wesentlichen in dem mess- oder abschlussseitigen Einschieben einer starren Baugruppe besteht, ändern würde. Dies ermöglicht ein einheitlicheres Fertigungsverfahren und damit reduzierte Kosten.

Besondere Bedeutung kommt für das erfindungsgemäße Verfahren und die erfindungsgemäße Baugruppe 28 der Schirmhülse 30 zu, die als zylindrische Schirmhülse zur Abschirmung gegen elektromagnetische Strahlung für den darin aufgenommenen Träger mit einer elektronischen Schaltung ausgebildet ist. Die Schirmhülse 30 weist messseitig und anschlussseitig jeweils eine Öffnung auf und ist außerdem dadurch gekennzeichnet, dass beliebig am Umfang der Schirmhülse, jedoch in besonders vorteilhafter Ausgestaltung der erfindungsgemäßen Einrichtung endseitig, mindestens eine Kontaktierungslasche für die elektronischen Schaltkreise vorgesehen ist und dass endseitig und messseitig jeweils mindestens eine schlitzartige Ausnehmung in dem Hülsenkörper vorhanden ist.

Die Schirmhülse 30 dient also als Schirmung und zugleich als mechanischer Zusammenhalt für die starre Baugruppe 28. Sie nimmt zudem die Kraft beim Einschieben der Baugruppe 28 in die Gehäusehülse 14 auf.

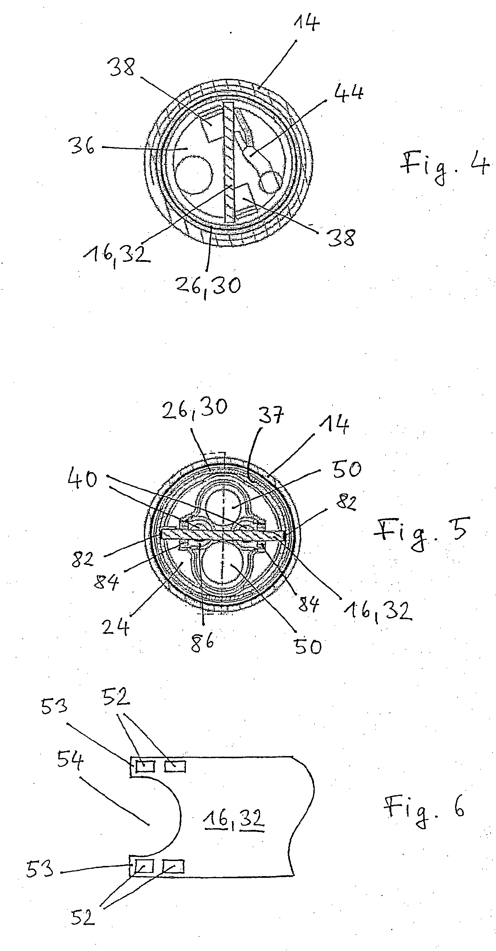

Besonders effektiv ist die Abschirmung der elektromagnetischen Strahlung, sofern für das Sensorprinzip erforderlich, wenn die Schirmhülse 30 mit einem nachstehend noch zu beschreibenden Schirmbecher 36 für die Sensoreinheit 12 kombiniert wird, da dann ein einseitig geschlossener Schirmtubus entsteht. Vorteilhaft ist außerdem, dass durch die Schirmhülse 30 eine zusätzliche mechanische Stabilität der starren Baugruppe 28 erzielt wird. Die einzügige Montage des Schaltgeräts, insbesondere das Einschieben der Baugruppe 28 in die Gehäusehülse 14 wird außerdem durch die starre Schirmhülse erleichtert, da sie zwischen der Sensoreinheit 12 und dem Anschlussteil 24 auftretende Kräfte aufnehmen kann. Hierdurch werden die zungenartigen Bereiche 53 am Ende der Ausnehmungen 54 des Trägers (vgl. Fig. 6) mechanisch nicht belastet, sofern diese vorteilhafterweise einen Abstand zwischen Träger 16 und Bodenwandung des Abschlusses 24 zur Aufnahme der Fertigungstoleranzen aufweisen.

Diese Möglichkeit der Abschirmung eignet sich für alle gängigen zylindrischen Gehäusedurchmesser in der Automatisierungstechnik, insbesondere M12, M18 und M30 oder sonstige Durchmesser.

Durch geeignete Isolationsspalte, die außerdem zum Vergießen und/oder Ausspritzen mit Isolationsmasse bzw. zur Entlüftung beim Vergießen dienen können, wird die Isolationsfestigkeit des Sensors definiert. Die Zentrierung der Baugruppe 28 wird in diesem Fall über Endabschluss 24 und messseitigen Wandlerschirmbecher 64 vorgenommen.

Das elektrische Kontaktieren und eine zusätzliche mechanische Stabilität kann durch eine Löt- oder Kontaktierungslasche erzielt werden. Bei ausreichender Größe der genannten Vergussöffnungen bzw. Vergussschlitze oder derart gestalteten Ausnehmungen gestaltet sich auch das manuelle Anlöten der Kontaktierungslasche, auch bei der fertigen Baugruppe 28, sehr einfach.

Die ausreichende Größe der Vergussöffnungen und/oder -schlitze ermöglicht darüber hinaus das lunkerfreie Vergießen der Baugruppe mit einer Vergussmasse. Bevorzugt wird, insbesondere wenn im Anschlussteil 24 Leuchtmittel, insbesondere in mindestens mehr als einem Segment, in besonders vorteilhafter Ausgestaltung in vier Quadranten angeordnete Leuchtdioden, vorgesehen sind, eine transparente und/oder semitransparente Vorvergussmasse und/oder Vergussmasse verwendet. Ein Vorverguss kann dabei einen besseren Zusammenhalt der starren Baugruppe 28 bewirken.

Die Vergussöffnungen oder -schlitze oder derart gestaltete Ausnehmungen in der Schirmhülse 30 dienen neben dem Verteilen der Vergussmasse in einem Isolationsspalt als mechanisches Federelement, das sich auf die in vorteilhafter Ausgestaltung als Schirmbecher geformte messseitige Zentrierung der Schirmung und/oder eines dergestalt hergestellten Verbindungselements der Sensoreinheit 12 aufpressen lässt.

Eine Innenfläche der Gehäusehülse 14, die in Figur 1 in einer einfachen, vollständig durchgedrehten Ausführung ohne Absatz gezeigt ist, dient als Dichtfläche für umlaufende Dichtlippen des jeweils verwendeten transparenten Anschlussteils 24 bzw. für entsprechende Dichteinrichtungen der jeweiligen Sensoreinheit. Diese Dichteinrichtungen werden nachstehend noch genauer erläutert. Das Anschlussteil 24 kann für mindestens einen Kabelabgang und/oder dergestalt ausgebildeten elektrischen und/oder mechanischen Anschluss ausgelegt sein.

Die Innenfläche der Gehäusehülse 14 kann in besonders vorteilhafter Ausgestaltung eine Verjüngung aufweisen, die dazu dient, einen voll transparenten, semitransparenten oder nicht transparenten Endabschluss 24 oder einen Steckereinsatz mit mindestens einer umlaufenden Dichtlippe nochmals zu pressen, sofern die Baugruppe 28 bereits fast komplett in die Gehäusehülse 14 eingeschoben worden ist.

Die Gehäusehülse 14 kann insbesondere ein Außengewinde mit allen in der Automatisierungstechnik gängigen Größen, d.h. M12, M18, M30 usw. aufweisen oder eine dergestalt ähnlich ausgeformte zylindrische Gehäusehülse sein.

Die Gehäusehülse 14 kann außerdem einen mess- oder endseitigen Anschlag für die starre Baugruppe 28 aufweisen. Dieser Anschlag kann insbesondere mit einer Kante an der Sensoreinheit 12 und/oder an dem Abschlusselement 24 nach dem vollständigen Einschieben der Baugruppe 28 in Eingriff kommen. Auf diese Weise wird die Länge des Schaltgeräts exakt definiert.

Ein erstes Beispiel eines mit dem erfindungsgemäßen Verfahren. hergestellten Schaltgeräts 10 ist in den Figuren 2 und 3 in Schnittansichten dargestellt. Äquivalente Komponenten sind jeweils mit denselben Bezugszeichen gekennzeichnet.

In eine Gehäusehülse 14 wurde dabei von einer Messseite 22 eine erfindungsgemäße Baugruppe 28 eingeführt. Diese Baugruppe 28 besteht aus einer Sensoreinheit 12 mit einem Sensor 13, einem als Leiterplatte 32 ausgebildeten Träger 16 mit einer elektronischen Schaltung 18, einer als Schirmhülse 30 ausgebildeten Schirmung 26 und einem Anschlussteil 24. Im gezeigten Beispiel ist das Anschlussteil 24 an einem dem Messende 22 gegenüberliegenden Hinterende 20 der Gehäusehülse als transparentes Anschlussteil 24 mit Kabelabgang ausgebildet. Über Anschlussleitungen 46, 48, für die in dem Anschlussteil 24 geeignete Öffnungen vorgesehen sind, ist die elektronische Schaltung 18 auf der Leiterplatte 32 mit externen Geräten verbunden. Die Sensoreinheit 12 ist mit einer Schirmbuchse 36, die auch als Schirmbecher bezeichnet werden kann, versehen. Diese Schirmbuchse 36 weist an ihrem Bodenbereich, d.h. an dem dem Messende 22 gegenüberliegendem Ende eine Verjüngung, auf, in die die Schirmhülse 30 sowohl elektrisch kontaktierend als auch mechanisch stabilisierend und zentrierend eingreift. Die Sensoreinheit 12 ist über eine Anschlussleitung 44 mit der elektronischen Schaltung 18 verbunden. Wie in Figur 4 gezeigt, erfolgt eine elektrische Kontaktierung des Schirmbechers 36 zur Leiterplatte außerdem über Kontaktlaschen 38, die beidseitig mit der Leiterplatte 32 verbunden, insbesondere verlötet, sind.

Eine Schnittansicht des in den Figuren 2 und 3 gezeigten Schaltgerätes 10 in Richtung des hinterseitigen Endes 20, d.h. in Richtung des Anschlussteils 24, ist in Figur 5 gezeigt. Insbesondere ist dort die zentrische Anordnung der Leiterplatte 32 bezüglich des Anschlussteils 24 ersichtlich. Zur Aufnahme der Leiterplatte 32 in dem Anschlussteil 24 sind dort im Innenbereich Führungsnuten 82 sowie schienenartige Führungen 84 vorgesehen. Die schienenartigen Führungen 84 sind dabei an den Außenseiten von Buchsen 86 ausgebildet. Diese Buchsen 86 schließen sich an Durchgangsöffnungen 40 an, die zum Befüllen des Innenraums des Schaltgeräts 10 mit einem Vergussmaterial vorgesehen sind. Außerdem ist im Bereich der Eingangsöffnungen der Führungsnuten 82 eine Einführ- und zentrierhilfe in Form einer sich nach außen hin zunehmend aufweitenden Öffnung vorgesehen. Der Kabelabgang ist im gezeigten Beispiel zweifach ausgebildet, d.h. es sind Durchgangsöffnungen 50 für zwei Anschlussleitungen vorgesehen. Entsprechend kann auch nur ein Kabelanschluss oder es können eventuell mehr als zwei Anschlüsse vorgesehen werden. Die Durchgangsöffnungen 50 sind zur Bereitstellung einer Torsions- und Zugentlastung für die Kabel mit einer Verzahnung in Form von Rillierungen versehen. Außerdem verjüngen sich die Öffnungen 50 in Richtung des Inneren des Schaltgeräts 10. Auf diese Weise wird eine Abdichtung durch den elastischen Kabelmantel nach außen hin erzielt. Schließlich wird dadurch auch zusätzlich zur Schleifenverlegung der Kabellitzen eine Zugentlastung für das bzw. die Kabel erzielt.

Ein vereinfachtes Zusammenfügen der Baugruppe 28, insbesondere das Anfügen des Anschlusses 24 an die Leiterplatte 32, wird bei der in den Figuren 2 und 3 dargestellten Kabelvariante durch die Federkraft, d.h. durch die Rückzugkraft der mit Zugentlastungsschleifen eingebrachten und auf der Leiterplatte 32 fixierten Anschlussleitungen erreicht.

Der Zusammenhalt der Baugruppe 28 wird bei der in den Figuren 2 und 3 dargestellten Kabelvariante durch das punktweise verklebende Verbinden von Anschluss 24 und Schirmhülse 30 sowie Schirmhülse 30 und becherförmiger Buchse 36, jeweils an den radialen Außenrändern der zu verbindenden Elemente, gewährleistet.

Dem. Zusammenhalt der Baugruppe 28 dient weiterhin ein eventueller ergänzender transparenter und/oder semitransparenter Vorverguss oder eine Vorverklebung des volltransparenten und/oder semitransparenten Anschlussteils 24 für Kabel und/oder Steckervariante.

Ein Vergießen des Sensorinneren kann über die Öffnungen 40, die auch als Vergusslöcher 40 bezeichnet werden können, erfolgen. Insbesondere kann über die Ausnehmungen in der Schirmhülse 30 auch ein Vorverguss mit einer transparenten und/oder semitransparenten Vergussmasse, insbesondere bis zur Höhe der Buchsen 86, die auch als Kamine bezeichnet werden können, erfolgen.

Der Verguss kann dabei als Steig- und/oder Vakuumverguss durchgeführt werden und/oder durch Einspritzen von Duroplasten erfolgen. Zum Schwerkraftsteigverguss werden zur Befüllung und zur Entlüftung zwei Vergusslöcher benötigt. Die Vergussmasse wird durch eine oder zwei Buchsen 86 oder Kamine ins Innere geleitet. Die gezeigte kaminartige Ausführung ermöglicht einen Vorverguss mit transparenter Vergussmasse für die mindestens eine Leuchtanzeige und in vorteilhafter Ausgestaltung der Erfindung Vier-Quadranten-Anzeige. An den Außenseiten der Buchsen 86 sind für die schienenartigen Führungen 84 wiederum Einführschrägen für die Leiterplatte 32 ausgebildet. Für einen Vakuumverguss wird nur ein Vergussloch benötigt. Beide Vergusstechniken lassen sich auf die Abschlussvariante mit mindestens einem Kabelabgang und/oder mit mindestens einem Geräteanschluss realisieren.

Da sich gleichermaßen bei den Anschlusseilen 24 für Steckereinsatz sowie Kabelanschluss eine Verjüngung 37 des Durchmessers zwischen dem Boden des Anschlussteils bis hinauf zu den kaminartigen Buchsen 86 befindet, die nur durch die Führungsnut 82 mit Einführschräge unterbrochen wird, kann in besonders vorteilhafter Ausgestaltung der Erfindung und im Zusammenspiel mit den schienenartigen Führungen 84 die Leiterplatte 32 exakt und definiert im Anschlussteil 24 positioniert werden. Durch die Einführschrägen an beiden Seiten der Führungsnut 82 gleitet die Leiterplatte 32 bei azimutal fehlerhafter Winkellage beim Aufsetzen der Leiterplatte 32 auf die definierte Verjüngung 37 des Durchmessers praktisch selbstständig in die Führungsnuten 82, indem eine leichte Relativdrehung von Abschluss 24 oder Leiterplatte 32 manuell durchgeführt wird. Hierdurch wird die Fertigungsfreundlichkeit und deren Effizienz erheblich erhöht.

Ein Detail der Leiterplatte 32 ist in Figur 6 dargestellt. Entsprechend den Innenmaßen der verwendeten Schirmhülse 30 weist die Leiterplatte 32 grundsätzlich die Form eines länglichen Rechtecks auf. An der gezeigten Stirnseite dieses Rechtecks ist eine etwa halbrundartige oder eine rechteckförmige oder dergestalt ausgeprägte Ausnehmung 54 eingebracht, durch die an den beiden Rändern jeweils zungenartige Bereiche 53 gebildet sind. Auf diesen Bereichen sind jeweils auf Unterund/oder auch auf der Oberseite der Leiterplatte als Leuchtmittel mindestens eine, in vorteilhafter Ausgestaltung jedoch zwei oder auch mehr Leuchtdioden 52 angeordnet, über die eine Zustandsanzeige des Sensors oder elektrischen Schaltgeräts über ein transparentes Anschlussteil 24 nach außen gegeben werden kann. Die zungenartigen Bereiche 53 kommen im Einbauzustand mit den im Zusammenhang mit Figur 5 beschriebenen Führungsnuten 82 und den schienenartigen Führungen 84 des Anschlussteils 84 in Eingriff. Die Einführung wird dabei durch die dort beschriebenen Einführ- und Zentrierhilfen sowie durch die Einführschrägen an den Buchsen 86 erleichtert. Die Aussparung 54 erleichtert dabei außerdem eine kompakte Einführung der Sensorkabel oder der Steckeraufnahme mit einem Steckerelement 56. Die zungenartigen Bereiche 53, die auch als Ohren bezeichnet werden können, ermöglichen außerdem eine besonders gute Auskopplung der Lichtenergien für die im Weiteren nur noch als Vier-Quadranten-Anzeige bezeichnete Anzeige durch das voll transparente oder semitransparente Anschlussteil 24.

Die wesentliche Neuerung bei der Variante mit Kabelabgang besteht vor allem in der Kombination des sehr kompakt gehaltenen Kabelabgangs im Rahmen des volltransparenten und/oder semi-transparenten Anschlussteils 24 und der größtmöglichen Abstrahlfläche für die Leuchtmittel 52, d.h. insbesondere die Leuchtdioden. Im gezeigten Beispiel ist die Anordnung der Leuchtdioden zusammen mit der speziellen Ausformung der Leiterplatte 32 als Mehrsegment-Anzeige, insbesondere Zweisegment-Anzeige oder Vier-Quadranten-Anzeige ausgeführt.

Bei der nachstehenden Variante eines Anschlussteils 24 mit einem voll transparenten, semitransparenten oder nicht transparenten Steckereinsatz sind diese Ohren nicht notwendig. Die Leiterplatte weist außerdem Lötpads für mindestens eine, in besonders vorteilhafter Ausgestaltung für die beiden Kontaktlaschen 38 des Schirmbechers 36, sowie für mindestens eine oder mehrere entsprechende Kontaktlaschen der Schirmhülse 30 auf.

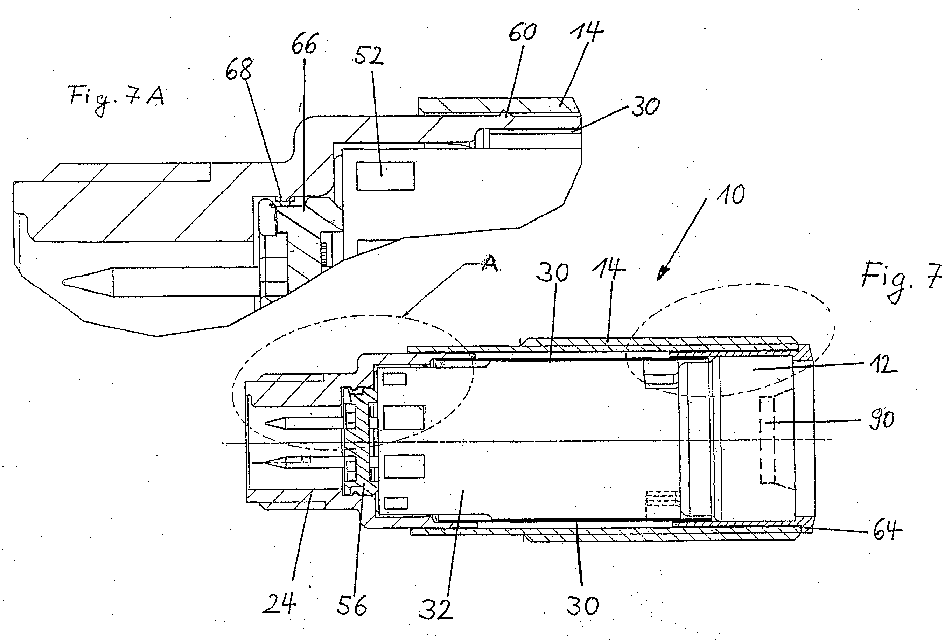

Eine Variante eines erfindungsgemäß herstellten Schaltgeräts 10 mit Steckereinsatz 56 in einer Rastversion, wobei die Montage von der Messseite her erfolgt, ist in Figur 7 und mit dem Ausschnitt A etwas vergrößert in Fig. 7A dargestellt. Das Anschlusateil 24 ist hierbei bevorzugt als transparente Steckeraufnahme mit einem Steckerelement 56 ausgestattet. Obwohl ein transparentes Material für die Steckeraufnahme bevorzugt wird, kann auch ein semitransparentes oder nicht transparentes Material Verwendung finden.

Das Wandlerelement 90 der Sensoreinheit 12 ist dabei primär axial ausgerichtet. Jedoch ist auch die Verwendung einer gewinkelten Sensoreinheit 12 mit einer Strahlung im Wesentlichen in einem Winkel zur Längsachse, insbesondere um etwa 90°, möglich.

Das Steckerelement 56 kann über seine Anschlusspins mit der Leiterplatte verlötet sein. Am messseitigen Ende ist durch den radialen Kragen an der Wandleraufnahme 64 ein Anschlag frontseitig mit der Gehäusehülse gebildet, wobei Lippendichtungen gegenüber der inneren Umfangswandung der Gehäusehülse 14 am Außenumfang der Wandleraüfnahme vorgesehen sein können.

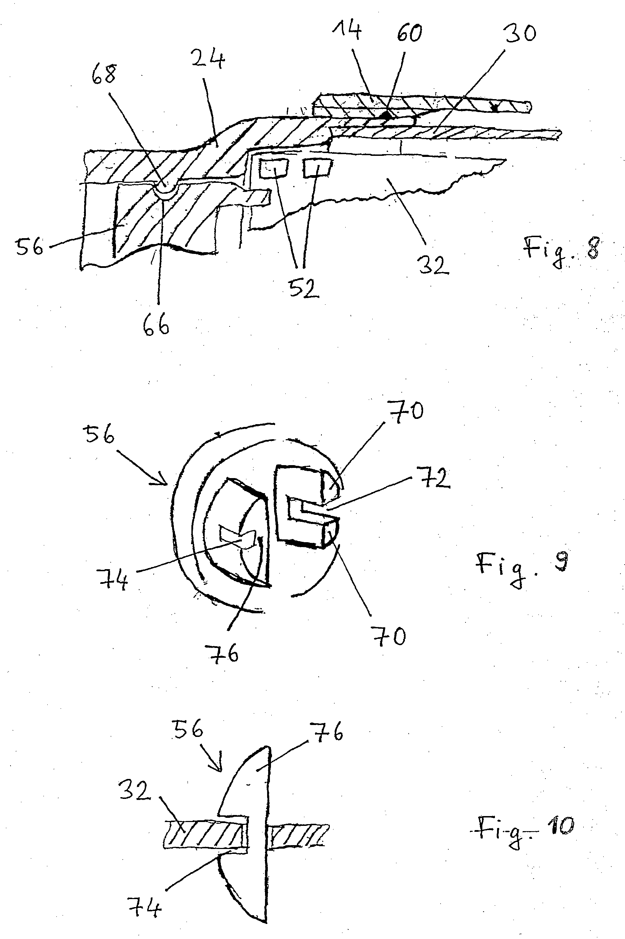

Weitere Details gemäß Ausschnitt A sind auch in der nachfolgenden Figur 8 in etwas vergrößerter Form gezeigt.

Eine bevorzugte Möglichkeit der Abdichtung bei einem Ausführungsbeispiel mit Steckerelement 56 ist in Figur 8 schematisch dargestellt. Dort wird eine Abdichtung zwischen dem Anschlussteil 24 und dem Steckerelement 56 über eine auf einer Innenseite des Anschlussteils 24 ausgebildete umlaufende Wulst 68 sowie eine entsprechend an dem Steckerteil 56 auf dessen Außenseite eingearbeitete umlaufende Nut 66 bereitgestellt. Die umlaufende Wulst 68 kann auch als Schnapplippe bezeichnet werden und dichtet das Innere des Schaltgeräts 10 zusammen mit der Nut 66 hermetisch ab. Diese Verbindung kann insbesondere als Klickverschluss ausgebildet sein und gibt dem Aufbau darüber hinaus mechanischen Halt. Durch das Einrasten des formstabil mit der Leiterplatte verbundenen Steckereinsatzes 56 mit dem dazugehörigen Endabschluss kann auf ganz besonders einfache Weise eine Formstabilität der Baugruppe 28 ohne die Notwendigkeit eines Vorvergusses und/oder einer Klebeverbindung mit der Schirmung 26 erreicht werden.

Das Anschlussteil 24 kann zur Verbesserung der mechanischen Stabilität der Gewinde und/oder der Abbruchsicherheit auch in Kunststoff eingelegte Metallteile zur Gewindeverstärkung aufweisen. In weiterer vorteilhafter Ausgestaltung kann das Anschlussteil jedoch in Vollmetallausführungen mit axial gestreckten Schlitzen bestehen, die mit transparenten und/oder semitransparenten Kunstofffenstern ausgeführt sind, so dass der metallische Anschluss bei gegebener höherer mechanischer Stabilität auch die Mehrsegment-Anzeige ermöglicht. Eine Ausführung des Anschlussteils 24 kann damit sowohl in Vollkunststoff und/oder Vollkunststoff mit Metalleinlegeteilen und/oder Vollmetall mit transparenten und/oder semitransparenten Kunstoffeinlegeteilen ausgeführt werden.

Ein praktisch automatisch richtiges Positionieren der Leiterplatte 32 bezüglich des Steckerelements 56 und des Anschlussteils 24 mit einer Passnase für externe Geräteanschlüsse wie z.B. Buchsen, kann durch geeignete Formgebung des Steckerelements 56 in Kombination mit dem Einführmechanismus nach Fig. 5 in erfindungsgemäßer Ausgestaltung der Führungsnuten 83, der schienenartigen Führungen 84, welche die Positionierung der Leiterplatte 32 in dem Anschlussteil festlegt, realisiert werden, die unter Bezugnahme auf die schematischen Figuren 9 und 10 beschrieben wird.

An einer der Innenseite des Schaltgeräts 10 zugewandten Seite des Steckerteils 56 sind dabei asymmetrisch geformte Passnasen 70, 76 vorgesehen. Während die Passnase 70 eine durchgehende Codiernut 72 aufweist, ist die gegenüberliegende Passnase 76 mit einer nur nach außen offenen Codiernut 74 versehen. Bei entsprechend geformter Leiterplatte 32 kann diese also nur in einer bestimmten Orientierung in die Codiernuten 72, 74 eingreifen. Der formschlüssige Eingriff eines Teilbereichs der Leiterplatte 32 mit der halb offenen Codiernut 74 an der Passnase 76 ist in Figur 10 in einer Schnittansicht schematisch gezeigt.

Die vier aus dem Steckerelement 56 herausstehenden viertelzylindrischen Passnasen 70, 76 führen die Leiterplatte 32 in die dazwischen liegenden Nuten 72, 74. Die Codiernase 76 greift in die Ausnehmung 54 der Leiterplatte 32 ein. Hierdurch wird das Steckerelement 56 eindeutig zu dem Anschlussteil 24 ausgerichtet, da dieses selbst ebenfalls durch die Führungsnuten 82 und schienenartigen Führungen 84 relativ zur Leiterplatte 32 eindeutig ausgerichtet wird. In einer vorteilhaften Ausgestaltung der Erfindung kann auf die Codiernut 74 verzichtet werden, wenn die Passnase 76 voll ausgeführt wird. Dann ist eine etwas breitere Ausnehmung 54 auf der Leiterplatte 32 notwendig. In einer weiteren vorteilhaften Ausgestaltung der Erfindung kann auf die genannte Ausnehmung 54 völlig verzichtet werden, wenn eine sichtbar überstehende Codiernasenpaarung ähnlich wie die Passnasen 70 nur über einer Seite bzw. Oberfläche der Leiterplatte 32, d.h. asymmetrisch, liegt und/oder dergestalt in ähnlicher Weise eindeutig durch Kennzeichnung offensichtlich gemacht wird und bei der Montage visuell auf die richtige Codierung geachtet wird.

Auch das volltransparente Anschlussteil 24 kann an den Enden einer Leiterplatte 32 mehr als nur eine verschiedenfarbige Leuchtdiode aufnehmen. Hierin liegt ein großer Vorteil.der Konstruktion. Eine Quasi-Rundum-Sichtbarkeit wird dadurch ermöglicht. Wichtig ist auch bei der Steckervariante des Schaltgeräts 10, dass das Fertigungsverfahren exakt dasselbe ist, wie bei.der Kabelausführüng. Auch hier werden alle mechanischen Elemente durch das volltransparente Anschlussteil 24 schon vor der endgültigen Montage der Baugruppe 28 koaxial aufgebaut und in der Gehäusehülse 14 zentriert.

Durch die beschriebene Codierung für das Steckerelement 56 wird außerdem eine Verdrehsicherheit erzielt. Wie oben im Zusammenhang mit der Variante des Anschlussteils 24 als Kabelabgang beschrieben, können auch im gezeigten Beispiel eines Steckeranschlussteils entsprechende Vergusslöcher vorgesehen werden. Die Zahl der Anschlusspins kann variiert werden. Insbesondere kann bei vier Anschlusspins ein zentrisches Vergussloch oder bei fünf Steckerpins mindestens ein exzentrisches Vergussloch vorgesehen werden. Das z.B. als voll transparenter Steckereinsatz ausgebildete Anschlussteil 24 kann außerdem mit einem Außengewinde zur Aufnahme von Steckverbindern versehen werden.

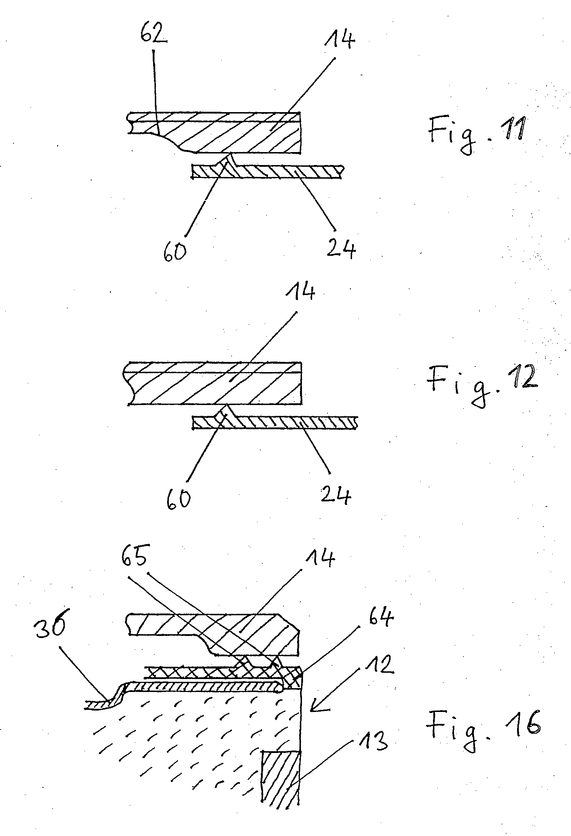

In den Figuren 11 und 12 sind Details der Verbindung zwischen Anschlussteil 24 und Gehäusehülse 14 dargestellt. Um eine dichtende Verbindung zu erzielen, die außerdem zusätzliche mechanische Stabilität ergibt, kann mindestens eine umlaufende Dichtlippe 60 an einer Außenseite des Anschlussteils 24 vorgesehen sein.

In dem in Figur 11 gezeigten Beispiel weist die Gehäusehülse 14 eine Verjüngung 62 auf, die je nach einzügiger Einzugsrichtung der Baugruppe 28, mess- oder anschlussseitig angeordnet ist, welche ein Verpressen der plastisch verformbaren Dichtlippen oder Dichteinheiten ermöglicht, sobald die Baugruppe 28 fast vollständig eingeschoben wurde.

Bei der einzügigen Montage der Baugruppe 28 vom messseitigen Ende der Gehäusehülse 14, dient die in axialer Richtung frontseitig deutende Fläche der Gehäusehülse 14 als Anschlag der Baugruppe 28 mit dem erweiterten Radius der Wandleraufnahme 64. Hierbei befindet sich die Verjüngung in der Gehäusehülse 14 am anschlussseitigen Ende.

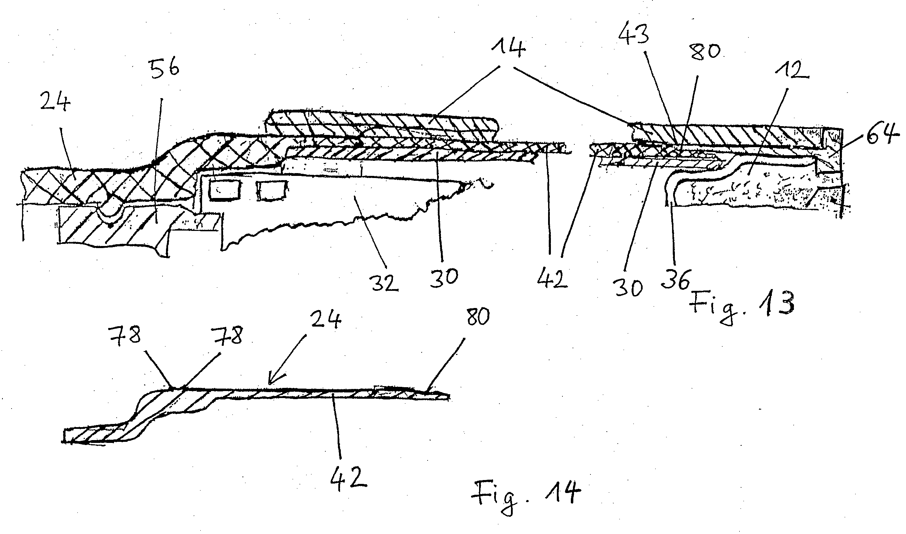

Eine besonders vorteilhafte Variante eines Anschlussteils 24 wird unter Bezugnahme auf die Figuren 13 und 14 beschrieben. Gezeigt ist eine Ausführungsform mit einem Steckereinsatz 56. Diese Ausführungsform ist auch mit einem zuvor beschriebenen Kabelabgang möglich.

Das Anschlussteil 24 weist dabei einen langgestreckten Kragen oder Isolierkragen 42 auf, der sich bei zusammengebautem Schaltgerät praktisch über die gesamte axiale Länge der Schirmhülse 30 erstreckt und den Raum zwischen Schirmhülse 30 und Gehäusehülse 14, der auch als Isolierspalt bezeichnet werden kann, vollständig ausfüllt. Auf diese Weise wird eine sehr hohe Spannungsfestigkeit und Betriebssicherheit erreicht, insbesondere das Einhalten nach Schutzklasse 2, sofern die Außendurchmesser eine entsprechende Dimensionierung zulassen. Außerdem wird dabei das Eindringen von Wasser verhindert. An dem Isolierkragen 42 ist eine konische Überlappung 80 mit der Schirmbuchse 36 bzw. eine Unterlappung mit der zylindrischen Wandleraufnahme 64 vorgesehen, die sich unter einen zylindrischen Ausläufer der Wandleraufnahme 64 der Sensoreinheit 12 schiebt. Gegebenenfalls kann der Isolierkragen 42 bei der Endmontage mit der Gehäusehülse 14 verklebt werden. Umlaufende Dichtlippen 78 schließen das Innere der Klebefuge des Schaltgeräts 10 hermetisch ab und sorgen außerdem für einen zusätzlich kraftschlüssigen Zusammenhalt zwischen Gehäusehülse 14 und Anschlussteil 24. Eine Zentrierung von Schirmhülse 30, Leiterplatte 32 und der Baugruppe 28 insgesamt bezüglich zur Gehäusehülse 14 kann über eine in dem Anschlussteil 24 ausgebildete Zentrierung sowie über den langgestreckten Kragen erzielt werden. In der bereits vorstehend im Zusammenhang mit den Figuren 9 und 10 beschriebenen Weise erfolgt auch hier eine Codierung der Leiterplatte 32, so dass diese nur in einer eindeutigen Weise in das Steckerelement 56 einführbar ist. Die Durchmesser der Komponenten sind insgesamt so gestaltet, dass der voll transparente Steckereinsatz 24 durch die Gehäusehülse 14 geschoben werden kann. Das als Steckereinsatz ausgebildete Anschlussteil 24 kann außerdem als Mehrsegment-, insbesondere Zweisegment- oder Vier-Quadranten-LED-Anzeige ausgebildet sein. Ein in dem Anschlusselement 24 ausgebildeter Wulst verhindert außerdem ein schräges Einschieben der Leiterplatte 32 sowie ein Verdrehen des Anschlussteils 24.

Durch den längs gestreckten Isolierkragen 42 wird neben einer höheren Spannungsfestigkeit auch das Eindringen von Wasser durch Dehnungsfugen bei Materialbeanspruchung mit Wechseltemperaturen deutlich erschwert. Hierbei überlappt der langgestreckte Isolierkragen 42 an der Überlappungsstelle 43 mit der Sensoreinheit 12. Gegebenenfalls muss der Isolierkragen 42 mit der Gehäusehülse 14 verklebt werden.

Bei den in den Figuren 7, 8 und 13 gezeigten Steckervarianten wird die Baugruppe 28 durch den umlaufenden Wulst 68 und die umlaufende Nut 66 in dem Steckereinsatz 56 zusammengehalten.

Eine Variante eines erfindungsgemäß hergestellten Schaltgeräts 10 mit Steckereinsatz mit Montage von der Anschlussseite her, ist in Figur 15 dargestellt. Dort ist das Anschlussteil 24 als transparente Steckeraufnahme mit einem Steckerelement 56 ausgebildet, wobei eine Abdichtung über einen O-Ring 58 bereitgestellt wird. Wie bei den in den Figuren 1 bis 6 gezeigten Beispielen erstreckt sich der Erfassungsbereich der Sensoreinheit 12 in axialer Richtung. Ebenso ist aber auch der Einbau von gewinkelten Sensoreinheiten 12, beispielsweise mit einem Erfassungsbereich quer zur Längsachse der Gehäusehülse 14, möglich. Das Steckerelement 56 kann über seine Anschlusspins mit der Leiterplatte 32 verlötet sein.
Details der Verbindung von Sensoreinheit 12 und Gehäusehülse 14 sind in Figur 16 dargestellt. Auch dort sind; um eine dichtende Verbindung zu erzielen, auf einer Außenseite einer buchsenförmigen Wandleraufnahme 64 umlaufende Dichtlippen 65 vorgesehen, die mit der Innenseite der Gehäusehülse 14 in Eingriff kommen.

Bei der einzügigen Montage der Baugruppe 28 vom anschlussseitigen Ende der Gehäusehülse 14 dient die in axialer Richtung frontseitig deutende Fläche der Gehäusehülse 14 als Anschlag der Baugruppe 28 mit dem erweiterten Radius des Abschlussstücks 24. Hierbei befindet sich die Verjüngung in der Gehäusehülse 14 am messseitigen Ende (vgl. Fig. 16).

Bei dem erfindungsgemäßen Verfahren sind bei der Herstellung eines Schaltgeräts mit Kabelabgang folgende Verfahrensschritte durchzuführen. Zunächst wird die Sensoreinheit 12 vormontiert. Anschließend wird die Sensoreinheit 12 über Kontaktlaschen 38 an die Leiterplatte 32 in einer Hilfseinrichtung angelötet, wodurch gleichzeitig die Leiterplatte 32 gegenüber der Sensöreinheit 12 zentriert wird. Daraufhin werden die Anschlussleitungen 46, 48 durch das transparente Anschlussteil 24 durchgezogen und die zylindrische Schirmhülse 30 wird auf die Kabel gezogen.

Im Folgenden werden die Kabelenden der Anschlussleitungen 46, 48 auf der Leiterplatte 32 angelötet. Es folgt dann eine Prüfung und ein Abgleich des Sensors, da die Elektronik in diesem Stadium noch zugänglich ist. Die Schirmhülse 30 wird dann über die Sensorelektronik gezogen. Eine vorderseitige Zentrierung und eine manuelle Verpressung der Schirmhülse 30 erfolgt über den Schirmbecher 36, der sich über der geraden oder gewinkelten Sensoreinheit 12 befindet. Hierbei wird gleichermaßen manuell die Kontaktierungslasche der Schirmhülse 30 auf das vorhandene Lötpad rotativ ausgerichtet.

Dann kann das Anschlussteil 24 aufgeschoben werden, wobei es hierbei manuell möglich ist, die Schirmhülse 30 und die Leiterplatte 32 mit den Leuchtmitteln 52 durch die Einführ- und Zentrierhilfen in dem Anschlussteil 24 in einem Schritt zu zentrieren und zu codieren. Die Schirmhülse 30 kann dann durch die dort entsprechend großzügig ausgebildete Öffnung oder Ausnehmung mit der Leiterplatte 32 kontaktiert bzw. angelötet werden und gegebenenfalls kann anschließend ein Vorverguss des transparenten Anschlussteils 24 durch diese Öffnungen, die in diesem Falle als Vergussöffnungen 40 dienen, durchgeführt werden.

Die Baugruppe 28 wird dann in die zylindrische Gehäusehülse 14 eingeschoben. Abschließend kann ein Vergießen, ein Verschäumen, ein Verpressen mit Kunststoffen, beispielsweise mit Duroplast, erfolgen. Gegebenenfalls kann aber auch auf ein Befüllen des ansonsten mechanisch hermetisch dichtenden Schaltgeräts verzichtet werden. Dies insbesondere dann, wenn die Baugruppe klebend mit der Außenhülse 14 verbunden wird.

Bei der Herstellung der Steckverbindervariante werden nach dem Anlöten der Sensoreinheit 12 an der Leiterplatte 32 die Pins des Steckerelements 56 auf der Leiterplatte 32 angelötet. Das Steckerelement 56 weist, wie beschrieben, eine umlaufende Nut 66 auf, in die eine Wulst 68 des Anschlussteils 24 beim Überschieben fest einrasten kann. Anschließend wird die Schirmhülse 30 aufgeschoben. Eine vorderseitige Zentrierung und manuelle Verpressung und Ausrichtung der Kontaktierungslasche der Schirmhülse 30 erfolgt wieder über den Schirmbecher 36 der Sensoreinheit 12.

Danach wird das Anschlussteil 24 aufgeschoben, wobei wieder die Leiterplatte 32 durch die Einführ- und Zentrierhilfe in dem Anschlussteil 24 zentriert und gegebenenfalls codiert wird. Beim Aufschieben des Anschlussteils rastet die Wulst 68 in die Nut 66 des Steckerelements 56 ein. Dadurch wird eine mechanisch leicht flexible Fixierung der Schirmhülse 30 mit der Leiterplatte 32 ermöglicht. Die Baugruppe 28 ist auf diese Weise in besonders vorteilhafter Weise eigenstabil, ohne dass Klebemittel bei der Vormontage dieser Baugruppe 28 verwendet werden müssen. Weiterhin wird eine hermetische steckerseitige Dichtung des Inneren des Schaltgeräts durch den Eingriff des Wulstes 68 in die Nut 66 ermöglicht. Alternativ dichtet ein O-Ring diese Stelle ab. Danach wird die nunmehr ebenfalls beidseitig zentrierte Schirmhülse 30, wie vorstehend für die Kabelabgangslösung beschrieben, durch die Vergussöffnung in der Schirmhülse 30 verlötet. Nach dem Einschieben der Baugruppe 28 in die zylindrische Gehäusehülse 14 kann das Innere des Schaltgeräts gegebenenfalls vergossen, verschäümt oder mit Kunststoffen verpresst werden.

Beide Verfahren gelten gleichermaßen, wenn der Anschluss 24 mit langgestrecktem Kragen 42 für Kabel- sowie Steckervariante ausgeführt wird.

Bei dem Herstellungsverfahren des Schaltgerätes mit einzügigere Montage von der Anschlussseite her gelten alle Verfahrensschritte wie vorausgehend zur Steckervariante beschrieben.

Das Einschieben der kompletten Baugruppe 28 erfolgt hierbei jedoch von der Anschlussseite her, bis das Anschlussteil 24 mit seiner radialen Anschlagfläche gegen die rückwärtige Stirnseite der Gehäusehülse 14 zur Anlage kommt.

## Patentansprüche (Patentansprüche für folgende(n) Vertragsstaat(en): FR, DE, GB)

1. Verfahren zur Herstellung eines Schaltgeräts mit einer Sensoreinheit (12), die an einem Messende (22) einer Gehäusehülse (14) angeordnet und mit einer elektronischen Schaltung (18) verbunden ist, die auf einem in der Gehäusehülse (14) aufgenommenen Träger (16) angeordnet ist, und
mit einem an einem Hinterende (20) der Gehäusehülse (14) angeordneten Anschlussteil (24),
**dadurch gekennzeichnet,**
**dass** die Sensoreinheit (12), der Träger (16) und das Anschlussteil (24) zusammen mit einer den Träger (16) umschließenden Schirmhülse (26) zur Abschirmung von elektromagnetischer Strahlung zu einer formstabilen Baugruppe (28) zusammengesetzt werden,
**dass** die Baugruppe (28) anschließend in die Gehäusehülse (14) eingeführt und dort fixierend aufgenommen wird und dass die Schirmhülse (30) mit dem Träger (16) elektrisch verbunden wird.

2. Verfahren nach Anspruch 1,
**dadurch gekennzeichnet,**
**dass** die Baugruppe (28) von dem Messende (22) her in die Gehäusehülse (14) eingeführt wird.

3. Verfahren nach Anspruch 1,
**dadurch gekennzeichnet,**
**dass** die Baugruppe (28) von dem Hinterende (20) her in die Gehäusehülse (14) eingeführt wird.

4. Verfahren nach einem der Ansprüche 1 bis 3,
**dadurch gekennzeichnet,**
**dass** die Baugruppe (28) dichtend in die Gehäusehülse (14) eingeführt wird.

5. Verfahren nach einem der Ansprüche 1 bis 4,
**dadurch gekennzeichnet,**
**dass** eine zylindrische Schirmhülse (30) und eine zylindrische Gehäusehülse (14) verwendet werden.

6. Verfahren nach einem der Ansprüche 1 bis 5,
**dadurch gekennzeichnet,**
**dass** der Träger (16) als Leiterplatte (32) ausgebildet ist und in ausgerichteten Eingriff mit der Sensoreinheit (12) gebracht wird und
**dass** die Leiterplatte (32) mit der Sensoreinheit (12) elektrisch verbunden wird.

7. Verfahren nach einem der Ansprüche 1 bis 6,
**dadurch gekennzeichnet,**
**dass** die Schirmhülse (26) definiert den Träger (16) umgebend mit der Sensoreinheit (12) in Anschlag gebracht wird.

8. Verfahren nach einem der Ansprüche 1 bis 7,
**dadurch gekennzeichnet,**
**dass** die Schirmhülse (26) definiert koaxial zur Sensoreinheit (12) und zur Gehäusehülse (14) ausgerichtet wird.

9. Verfahren nach einem der Ansprüche 1 bis 8,
**dadurch gekennzeichnet,**
**dass** bei der Baugruppe (28) in dem Anschlussteil (24) ein Vorverguss durchgeführt wird.

10. Verfahren nach einem der Ansprüche 1 bis 9,
**dadurch gekennzeichnet,**
**dass** ein Anschlussteil (24) mit mindestens einem Kabelabgang verwendet wird.

11. Verfahren nach einem der Ansprüche 1 bis 9,
**dadurch gekennzeichnet,**
**dass** ein Anschlussteil (24) mit mindestens einem Steckerabgang verwendet wird.

12. Verfahren nach einem der Ansprüche 1 bis 11,
**dadurch gekennzeichnet,**
**dass** das Anschlussteil (24) in definierter Ausrichtung mit dem Träger (16) auf einen endseitigen Bereich der Schirmhülse (30) aufgebracht wird.

13. Verfahren nach einem der Ansprüche 1 bis 12,
**dadurch gekennzeichnet,**
**dass** das Anschlussteil (24) definiert koaxial zu Gehäusehülse (14) und Schirmhülse (26) ausgerichtet wird.

14. Verfahren nach einem der Ansprüche 1 bis 13,
**dadurch gekennzeichnet,**
**dass** der Vorverguss mit einem nach Aushärtung transparenten oder semitransparenten Material durchgeführt wird.

15. Verfahren nach einem der Ansprüche 1 bis 14,
**dadurch gekennzeichnet,**
**dass** die Bereiche zwischen Träger (16) und Schirmhülse (26) sowie zwischen Schirmhülse (26) und Gehäusehülse (14) vergossen werden.

16. Verfahren nach einem der Ansprüche 1 bis 14,
**dadurch gekennzeichnet,**
**dass** ein Anschlussteil (24) mit einem langgestreckten Kragen (42) verwendet wird, der über die Schirmhülse (30) geschoben und mit der Sensoreinheit (12) in Anschlag gebracht wird.

17. Verfahren nach Anspruch 16,
**dadurch gekennzeichnet,**
**dass** der langgestreckte Kragen (42) koaxial zu Gehäusehülse (14) und Schirmhülse (26) ausgerichtet wird.

18. Verfahren nach einem der Ansprüche 16 oder 17,
**dadurch gekennzeichnet,**
**dass** der langgestreckte Kragen (42) mit der Wandleraufnahme (64) eine Unterlappung und/oder einen definierten Anschlag bildet.

19. Verfahren nach einem der Ansprüche 16 bis 18,
**dadurch gekennzeichnet,**
**dass** die Baugruppe (28) gegenüber der Gehäusehülse (14) durch Verguss und/oder gespritzte Duroplaste und/oder über eine Klebeverbindung gehalten wird.

20. Verfahren nach einem der Ansprüche 1 bis 19,
**dadurch gekennzeichnet,**
**dass** die Sensoreinheit (12), bevor sie mit der Schaltung (18) auf der Leiterplatte (32) verbunden wird in eine becherartige Schirmbuchse (36) eingesetzt wird.

21. Verfahren nach Anspruch 20,
**dadurch gekennzeichnet,**
**dass** an der Schirmbuchse (36) vorgesehene Kontaktlaschen (38) mit der Leiterplatte (32) verlötet werden.

22. Verfahren nach einem der Ansprüche 1 bis 21,
**dadurch gekennzeichnet,**
**dass** das Vergießen durch mindestens eine Öffnung (40) in dem Anschlussteil (24) durchgeführt wird.

23. Baugruppe für ein Schaltgerät zum Einbau in eine Gehäusehülse
mit einer Sensoreinheit (12) mit einem Sensor (13) zum Nachweis eines Messsignals,
mit einer auf einem Träger (16) angeordneten elektronischen Schaltung (18), wobei der Träger (16) an einem Messende mit der Sensoreinheit (12) formstabil verbunden ist und wobei die Schaltung (18) mit der Sensoreinheit (12) elektrisch verbunden ist, **gekennzeichnet durch**
eine mit dem Träger (16) elektrisch verbundene und diesen umschließende Schirmhülse (26) zur Abschirmung von elektromagnetischer Strahlung, die mit der Sensoreinheit (12) und/oder mit dem Träger (16) formstabil verbunden ist, und
ein Anschlussteil (24) für den Anschluss der Schaltung (18) an externe Geräte, das auf den Träger (16) und/oder auf die Schirmhülse (26) aufgesetzt ist.

24. Baugruppe nach Anspruch 23,
**dadurch gekennzeichnet,**
**dass** der Sensor (13) insbesondere als induktiver, optischer, kapazitiver, Temperatur-, Druck- und/oder Gassensor ausgebildet ist.

25. Baugruppe nach einem der Ansprüche 23 bis 24,
**dadurch gekennzeichnet,**
**dass** die Sensoreinheit (12) mit einer Schirmbuchse (36) und/öder einer mechanisch die Schirmhülse (26) zentrierenden Einheit versehen ist.

26. Baugruppe nach einem der Ansprüche 23 bis 25,
**dadurch gekennzeichnet,**
**dass** der Träger (16) als Leiterplatte (32) ausgebildet ist.

27. Baugruppe nach einem der Ansprüche 23 bis 26,
**dadurch gekennzeichnet,**
**dass** das Anschlussteil (24) einen langgestreckten Kragen (42) aufweist, der mit der Sensoreinheit (12) in Anschlag kommt.

28. Baugruppe nach einem der Ansprüche 23 bis 27,
**dadurch gekennzeichnet,**
**dass** die Räume zwischen Träger (16) und Schirmhülse (26) vergossen und/oder mit Isoliermasse ausgespritzt sind.

29. Baugruppe nach einem der Ansprüche 23 bis 28,
**dadurch gekennzeichnet,**
**dass** die Sensoreinheit (12) eine Wandleraufnahme (64) mit axialer Anordnung des Messwandlers (13) oder mit winkliger Anordnung des Messwandlers (13) aufweist.

30. Baugruppe nach einem der Ansprüche 23 bis 29,
**dadurch gekennzeichnet,**
**dass** der Endabschluss (24) für die Kabelvariante (46, 48) und für die Steckervariante (56) als, insbesondere austauschbare, Module ausgebildet sind.

## Patentansprüche (Patentansprüche für folgende(n) Vertragsstaat(en): AT, BE, BG, CH, CY, CZ, DK, EE, ES, FI, GR, HU, IE, IS, IT, LI, LT, LU, MC, NL, PL, PT, RO, SE, SI, SK, TR)

1. Verfahren zur Herstellung eines Schaltgeräts
mit einer Sensoreinheit (12), die an einem Messende (22) einer Gehäusehülse (14) angeordnet und mit einer elektronischen Schaltung (18) verbunden ist, die auf einem in der Gehäusehülse (14) aufgenommenen Träger (16) angeordnet ist, und mit einem an einem Hinterende (20) der Gehäusehülse (14) angeordneten Anschlussteil (24),
**dadurch gekennzeichnet,**
**dass** die Sensoreinheit (12), der Träger (16) und das Anschlussteil (24) zusammen mit einer den Träger (16) umschließenden Schirmhülse (26) zur Abschirmung von elektromagnetischer Strahlung zu einer formstabilen Baugruppe (28) zusammengesetztwerden,
**dass** die Baugruppe (28) anschließend in die Gehäusehülse (14) eingeführt und dort fixierend aufgenommen wird,
**dass** die Schirmhülse (30) mit dem Träger (16) elektrisch verbunden wird und dass ein Anschlussteil (24) mit einem langgestreckten Kragen (42) verwendet wird, der über die Schirmhülse (30) geschoben und mit der Sensoreinheit (12) in Anschlag gebracht wird.

2. Verfahren nach Anspruch 1,
**dadurch gekennzeichnet,**
**dass** die Baugruppe (28) von dem Messende (22) her in die Gehäusehülse (14) eingeführt wird.

3. Verfahren nach Anspruch 1,
**dadurch gekennzeichnet,**
**dass** die Baugruppe (28) von dem Hinterende (20) her in die Gehäusehülse (14) eingeführt wird.

4. Verfahren nach einem der Ansprüche 1 bis 3,
**dadurch gekennzeichnet,**
**dass** die Baugruppe (28) dichtend in die Gehäusehülse (14) eingeführt wird.

5. Verfahren nach einem der Ansprüche 1 bis 4,
**dadurch gekennzeichnet,**
**dass** eine zylindrische Schirmhülse (30) und eine zylindrische Gehäusehülse (14) verwendet werden.

6. Verfahren nach einem der Ansprüche 1 bis 5,
**dadurch gekennzeichnet,**
**dass** der Träger (16) als Leiterplatte (32) ausgebildet ist und in ausgerichteten Eingriff mit der Sensoreinheit (12) gebracht wird und
**dass** die Leiterplatte (32) mit der Sensoreinheit (12) elektrisch verbunden wird.

7. Verfahren nach einem der Ansprüche 1 bis 6,
**dadurch gekennzeichnet,**
**dass** die Schirmhülse (26) definiert den Träger (16) umgebend mit der Sensoreinheit (12) in Anschlag gebracht wird.

8. Verfahren nach einem der Ansprüche 1 bis 7,
**dadurch gekennzeichnet,**
**dass** die Schirmhülse (26) definiert koaxial zur Sensoreinheit (12) und zur Gehäusehülse (14) ausgerichtet wird.

9. Verfahren nach einem der Ansprüche 1 bis 8,
**dadurch gekennzeichnet,**
**dass** bei der Baugruppe (28) in dem Anschlussteil (24) ein Vorverguss durchgeführt wird.

10. Verfahren nach einem der Ansprüche 1 bis 9,
**dadurch gekennzeichnet,**
**dass** ein Anschlussteil (24) mit mindestens einem Kabelabgang verwendet wird.

11. Verfahren nach einem der Ansprüche 1 bis 9,
**dadurch gekennzeichnet,**
**dass** ein Anschlussteil (24) mit mindestens einem Steckerabgang verwendet wird.

12. Verfahren nach einem der Ansprüche 1 bis 11,
**dadurch gekennzeichnet,**
**dass** das Anschlussteil (24) in definierter Ausrichtung mit dem Träger (16) auf einen endseitigen Bereich der Schirmhülse (30) aufgebracht wird.

13. Verfahren nach einem der Ansprüche 1 bis 12,
**dadurch gekennzeichnet,**
**dass** das Anschlussteil (24) definiert koaxial zu Gehäusehülse (14) und Schirmhülse (26) ausgerichtet wird.

14. Verfahren nach einem der Ansprüche 1 bis 13,
**dadurch gekennzeichnet,**
**dass** der Vorverguss mit einem nach Aushärtung transparenten oder semitransparenten Material durchgeführt wird.

15. Verfahren nach einem der Ansprüche 1 bis 14,
**dadurch gekennzeichnet,**
**dass** die Bereiche zwischen Träger (16) und Schirmhülse (26) sowie zwischen Schirmhülse (26) und Gehäusehülse (14) vergossen werden.

16. Verfahren nach einem der Ansprüche 1 bis 14,
**dadurch gekennzeichnet,**
**dass** der langgestreckte Kragen (42) koaxial zu Gehäusehülse (14) und Schirmhülse (26) ausgerichtet wird.

17. Verfahren nach einem der Ansprüche 1 oder 16,
**dadurch gekennzeichnet,**
**dass** der langgestreckte Kragen (42) mit der Wandleraufnahme (64) eine Unterlappung und/oder einen definierten Anschlag bildet.

18. Verfahren nach einem der Ansprüche 1 bis 17,
**dadurch gekennzeichnet,**
**dass** die Baugruppe (28) gegenüber der Gehäusehülse (14) durch Verguss und/oder gespritzte Duroplaste und/oder über eine klebeverbindung gehalten wird.

19. Verfahren nach einem der Ansprüche 1 bis 18,
**dadurch gekennzeichnet,**
**dass** die Sensoreinheit (12), bevor sie mit der Schaltung (18) auf der Leiterplatte (32) verbunden wird in eine becherartige Schirmbuchse (36) eingesetzt wird.

20. Verfahren nach Anspruch 19,
**dadurch gekennzeichnet,**
**dass** an der Schirmbuchse (36) vorgesehene Kontaktlaschen (38) mit der Leiterplatte (32) verlötet werden.

21. Verfahren nach einem der Ansprüche 1 bis 20,
**dadurch gekennzeichnet,**
**dass** das Vergießen durch mindestens eine Öffnung (40) in dem Anschlussteil (24) durchgeführt wird.

22. Baugruppe für ein Schaltgerät zum Einbau in eine Gehäusehülse mit einer Sensoreinheit (12) mit einem Sensor (13) zum Nachweis eines Messsignals,
mit einer auf einem Träger (16) angeordneten elektronischen. Schaltung (18), wobei der Träger (16) an einem Messende mit der Sensoreinheit (12) formstabil verbunden ist und wobei die Schaltung (18) mit der Sensoreinheit (12) elektrisch verbunden ist,
**gekennzeichnet durch**
eine den Träger (16) elektrisch verbundenen und diesen umschließenden Schirmhülse (26) zur Abschirmung von elektromagnetischer Strahlung, die mit der Sensoreinheit (12) und/oder mit dem Träger (16) formstabil verbunden ist, und
einen Anschlussteil (24) für den Anschluss der Schaltung (18) an externe Geräte, das auf den Träger (16) und/oder auf die Schirmhülse (26) aufgesetzt ist, wobei das Anschlussteil (24) einen langgestreckten Kragen (42) aufweist, der über die Schirmhülse (30) geschoben und mit der Sensoreinheit (12) in Anschlag gebracht ist.

23. Baugruppe nach Anspruch 22,
**dadurch gekennzeichnet,**
**dass** der Sensor (13) insbesondere als induktiver, optischer, kapazitiver, Temperatur-, Druck- und/oder Gassensor ausgebildet ist.

24. Baugruppe nach einem der Ansprüche 22 bis 23,
**dadurch gekennzeichnet,**
**dass** die Sensoreinheit (12) mit einer Schirmbuchse (36) und/oder einer mechanisch die Schirmhülse (26) zentrierenden Einheit versehen ist.

25. Baugruppe nach einem der Ansprüche 22 bis 24,
**dadurch gekennzeichnet,**
**dass** der Träger (16) als Leiterplatte (32) ausgebildet ist.

26. Baugruppe nach einem der Ansprüche 22 bis 25,
**dadurch gekennzeichnet,**
**dass** das Anschlussteil (24) einen langgestreckten Kragen (42) aufweist, der mit der Sensoreinheit (12) in Anschlag kommt.

27. Baugruppe nach einem der Ansprüche 22 bis 26,
**dadurch gekennzeichnet,**
**dass** die Räume zwischen Träger (16) und Schirmhülse (26) vergossen und/oder mit Isoliermasse ausgespritzt sind.

28. Baugruppe nach einem der Ansprüche 22 bis 27,
**dadurch gekennzeichnet,**
**dass** die Sensoreinheit (12) eine Wandleraufnahme (64) mit axialer Anordnung des Messwandlers (13) oder mit winkliger Anordnung des Messwandlers (13) aufweist.

29. Baugruppe nach einem der Ansprüche 22 bis 28,
**dadurch gekennzeichnet,**
**dass** der Endabschluss (24) für die Kabelvariante (46,48) und für die Steckervariante (56) als, insbesondere austauschbare, Module ausgebildet sind.

## Claims (Claims for the following Contracting State(s): AT, BE, BG, CH, CY, CZ, DK, EE, ES, FI, GR, HU, IE, IS, IT, LI, LT, LU, MC, NL, PL, PT, RO, SE, SI, SK, TR)

1. Method for the manufacture of a switching device
having a sensor unit (12) located at a measurement end (22) of a casing sleeve (14) and connected to an electronic circuit (18) placed on a support (16) received in the casing sleeve (14) and
with a connection part (24) located on a rear end (20) of the casing sleeve (14), **characterized in that**
the sensor unit (12), the support (16) and the connection part (24) together with a shielding sleeve (26) surrounding the support (16) for shielding electromagnetic radiation are assembled to a dimensionally stable module (28),
**in that** the module (28) is subsequently inserted into the casing sleeve (14) where it is received in fixing manner and
**in that** the shielding sleeve (30) is electrically connected to the support (16).

2. Method according to claim 1,
**characterized in that**
the module (28) is introduced into the casing sleeve (14) from the measurement end (22).

3. Method according to claim 1,
**characterized in that**
the module (28) is introduced into the casing sleeve (14) from the rear end (20).

4. Method according to one of the claims 1 to 3,
**characterized in that**
the module (28) is sealingly inserted into the casing sleeve (14).

5. Method according to one of the claims 1 to 4,
**characterized in that**
use is made of a cylindrical shielding sleeve (30) and a cylindrical casing sleeve (14).

6. Method according to one of the claims 1 to 5,
**characterized in that**
the support (16) is constructed as a printed circuit board (32) and is brought into aligned engagement with the sensor unit (12) and
**in that** the circuit board (32) is electrically connected to sensor unit (12).

7. Method according to one of the claims 1 to 6,
**characterized in that**
the shielding sleeve (26), surrounding the support (16) in a defined manner, is brought into engagement with the sensor unit (12).

8. Method according to one of the claims 1 to 7,
**characterized in that**
the shielding sleeve (26) is oriented in a defined coaxial manner to the sensor unit (12) and the casing sleeve (14).

9. Method according to one of the claims 1 to 8,
**characterized in that**
a premoulding is performed with respect to the module (28) in the connection part (24).

10. Method according to one of the claims 1 to 9,
**characterized in that**
a connection part (24) with at least one cable departure is used.

11. Method according to one of the claims 1 to 9,
**characterized in that**
a connection part (24) with at least one plug departure is used.

12. Method according to one of the claims 1 to 11,
**characterized in that**
the connection part (24) is brought into a defined orientation with the support (16) on a terminal area of the shielding sleeve (30).

13. Method according to one of the claims 1 to 12,
**characterized in that**
the connection part (24) is oriented in a defined coaxial manner to the casing sleeve (14) and the shielding sleeve (26).

14. Method according to one of the claims 1 to 13,
**characterized in that**
the premoulding is carried out with a material which is transparent or semitransparent after curing.

15. Method according to one of the claims 1 to 14,
**characterized in that**
the areas between the support (16) and the shielding sleeve (26) and between the shielding sleeve (26) and the casing sleeve (14) are moulded.

16. Method according to one of the claims 1 to 14,
**characterized in that**
use is made of a connection part (24) with an elongated collar (42), which is engaged over the shielding sleeve (30) and engaged with the sensor unit (12).

17. Method according to claim 16,
**characterized in that**
the elongated collar (42) is oriented coaxially to the casing sleeve (14) and the shielding sleeve (26).

18. Method according to one of the claims 16 or 17,
**characterized in that**
the elongated collar (42) forms an underlap and/or a defined stop with the transducer receptacle (64).

19. Method according to one of the claims 16 to 18,
**characterized in that**
the module (28) is retained with respect to the casing sleeve (14) by means of moulding and/or extruded thermosetting resins and/or an adhesive joint.

20. Method according to one of the claims 1 to 19,
**characterized in that**
before the sensor unit (12) is connected to the electronic circuit (18) on the printed circuit board (32), it is placed in a cup-like shielding bush (36).

21. Method according to claim 20,
**characterized in that**
contact tabs (38) provided on the shielding bush (36) are soldered to the printed circuit board (32).

22. Method according to one of the claims 1 to 21,
**characterized in that**
moulding takes place through at least one opening (40) in the connection part (24).

23. Module for a switching device for installation in a casing sleeve,
having a sensor unit (12) with a sensor (13) for detecting a measurement signal, having an electronic circuit (18) placed on a support (16), in which the support (16) is dimensionally stably connected at a measurement end to the sensor unit (12) and in which the circuit (18) is electrically connected to the sensor unit (12),
**characterized in that**
a shielding sleeve (26) electrically connected to the support (16) and surrounding the latter for shielding electromagnetic radiation, which is connected in a dimensionally stable manner to the sensor unit (12) and/or the support (16), and a connection part (24) for the connection of the circuit (18) to external equipment and which is placed on the support (16) and/or the shielding sleeve (26).

24. Module according to claim 23,
**characterized in that**
the sensor (13) is constructed as, in particular an inductive, optical, capacitive, temperature, pressure and/or gas sensor.

25. Module according to one of the claims 23 or 24,
**characterized in that**
the sensor unit (12) is provided with a shielding bush (36) and/or a unit mechanically centring the shielding sleeve (26).

26. Module according to one of the claims 23 to 25,
**characterized in that**
the support (16) is constructed as a printed circuit board (32).

27. Module according to one of the claims 23 to 26,
**characterized in that**
the connection part (24) has an elongated collar (42), which engages with the sensor unit (12).

28. Module according to one of the claims 23 to 27,
**characterized in that**
spaces between the support (16) and the shielding sleeve (26) are moulded and/or are extruded with an insulating material.

29. Module according to one of the claims 23 to 28,
**characterized in that**
the sensor unit (12) has a transducer receptacle (64) with an axial arrangement of the measuring transducer (13) or an angular arrangement of the measuring transducer (13).

30. Module according to one of the claims 23 to 29,
**characterized in that**
the end termination (24) for the cable variant (46, 48) and for the plug variant (56) are constructed as, in particular replaceable modules.

## Claims (Claims for the following Contracting State(s): FR, DE, GB)

1. Method for the manufacture of a switching device
having a sensor unit (12) located at a measurement end (22) of a casing sleeve (14) and connected to an electronic circuit (18) placed on a support (16) received in the casing sleeve (14) and
with a connection part (24) located on a rear end (20) of the casing sleeve (14), **characterized in that**
the sensor unit (12), the support (16) and the connection part (24) together with a shielding sleeve (26) surrounding the support (16) for shielding electromagnetic radiation are assembled to a dimensionally stable module (28),
**in that** the module (28) is subsequently inserted into the casing sleeve (14) where it is received in fixing manner,
**in that** the shielding sleeve (30) is electrically connected to the support (16) and **in that** use is made of a connection part (24) with an elongated collar (42), which is engaged over the shielding sleeve (30) and engaged with the sensor unit (12).

2. Method according to claim 1,
**characterized in that**
the module (28) is introduced into the casing sleeve (14) from the measurement end (22).

3. Method according to claim 1,
**characterized in that**
the module (28) is introduced into the casing sleeve (14) from the rear end (20).

4. Method according to one of the claims 1 to 3,
**characterized in that**
the module (28) is sealingly inserted into the casing sleeve (14).

5. Method according to one of the claims 1 to 4,
**characterized in that**
use is made of a cylindrical shielding sleeve (30) and a cylindrical casing sleeve (14).

6. Method according to one of the claims 1 to 5,
**characterized in that**
the support (16) is constructed as a printed circuit board (32) and is brought into aligned engagement with the sensor unit (12) and
**in that** the circuit board (32) is electrically connected to sensor unit (12).

7. Method according to one of the claims 1 to 6,
**characterized in that**
the shielding sleeve (26), surrounding the support (16) in a defined manner, is brought into engagement with the sensor unit (12).

8. Method according to one of the claims 1 to 7,
**characterized in that**
the shielding sleeve (26) is oriented in a defined coaxial manner to the sensor unit (12) and the casing sleeve (14).

9. Method according to one of the claims 1 to 8,
**characterized in that**
a premoulding is performed with respect to the module (28) in the connection part (24).

10. Method according to one of the claims 1 to 9,
**characterized in that**
a connection part (24) with at least one cable departure is used.

11. Method according to one of the claims 1 to 9,
**characterized in that**
a connection part (24) with at least one plug departure is used.

12. Method according to one of the claims 1 to 11,
**characterized in that**
the connection part (24) is brought into a defined orientation with the support (16) on a terminal area of the shielding sleeve (30).

13. Method according to one of the claims 1 to 12,
**characterized in that**
the connection part (24) is oriented in a defined coaxial manner to the casing sleeve (14) and the shielding sleeve (26).

14. Method according to one of the claims 1 to 13,
**characterized in that**
the premoulding is carried out with a material which is transparent or semitransparent after curing.

15. Method according to one of the claims 1 to 14,
**characterized in that**
the areas between the support (16) and the shielding sleeve (26) and between the shielding sleeve (26) and the casing sleeve (14) are moulded.

16. Method according to one of the claims 1 to 14,
**characterized in that**
the elongated collar (42) is oriented coaxially to the casing sleeve (14) and the shielding sleeve (26).

17. Method according to one of the claims 1 or 16,
**characterized in that**
the elongated collar (42) forms an underlap and/or a defined stop with the transducer receptacle (64).

18. Method according to one of the claims 1 to 17,
**characterized in that**
the module (28) is retained with respect to the casing sleeve (14) by means of moulding and/or extruded thermosetting resins and/or an adhesive joint.

19. Method according to one of the claims 1 to 18,
**characterized in that**
before the sensor unit (12) is connected to the electronic circuit (18) on the printed circuit board (32), it is placed in a cup-like shielding bush (36).

20. Method according to claim 19,
**characterized in that**
contact tabs (38) provided on the shielding bush (36) are soldered to the printed circuit board (32).

21. Method according to one of the claims 1 to 20,
**characterized in that**
moulding takes place through at least one opening (40) in the connection part (24).

22. Module for a switching device for installation in a casing sleeve,
having a sensor unit (12) with a sensor (13) for detecting a measurement signal, having an electronic circuit (18) placed on a support (16), in which the support (16) is dimensionally stably connected at a measurement end to the sensor unit (12) and in which the circuit (18) is electrically connected to the sensor unit (12),
**characterized in that**
a shielding sleeve (26) electrically connected to the support (16) and surrounding the latter for shielding electromagnetic radiation, which is connected in a dimensionally stable manner to the sensor unit (12) and/or the support (16), and a connection part (24) for the connection of the circuit (18) to external equipment placed on the support (16) and/or the shielding sleeve (26),
in which the connection part (24) has an elongated collar (42), which is engaged over the shielding sleeve (30) and engaged with the sensor unit (12).

23. Module according to claim 22,
**characterized in that**
the sensor (13) is constructed as, in particular an inductive, optical, capacitive, temperature, pressure and/or gas sensor.

24. Module according to one of the claims 22 to 23,
**characterized in that**
the sensor unit (12) is provided with a shielding bush (36) and/or a unit mechanically centring the shielding sleeve (26).

25. Module according to one of the claims 22 to 24,
**characterized in that**
the support (16) is constructed as a printed circuit board (32).

26. Module according to one of the claims 22 to 25,
**characterized in that**
the connection part (24) has an elongated collar (42), which engages with the sensor unit (12).

27. Module according to one of the claims 22 to 26,
**characterized in that**
spaces between the support (16) and the shielding sleeve (26) are moulded and/or are extruded with an insulating material.

28. Module according to one of the claims 22 to 27,
**characterized in that**
the sensor unit (12) has a transducer receptacle (64) with an axial arrangement of the measuring transducer (13) or an angular arrangement of the measuring transducer (13).

29. Module according to one of the claims 22 to 28,
**characterized in that**
the end termination (24) for the cable variant (46, 48) and for the plug variant (56) are constructed as, in particular replaceable modules.

## Revendications (Revendications pour l'(les) Etat(s) contractant(s) suivant(s): AT, BE, BG, CH, CY, CZ, DK, EE, ES, FI, GR, HU, IE, IS, IT, LI, LT, LU, MC, NL, PL, PT, RO, SE, SI, SK, TR)

1. Procédé de fabrication d'un dispositif de commutation,
avec une unité de capteur (12), qui est disposée au niveau d'une extrémité de mesure (22) d'un manchon de boîtier (14) et reliée à un circuit électronique (18), lui-même disposé sur un support (16) logé dans le manchon de boîtier (14), et avec un élément de liaison (24) disposé au niveau d'une extrémité arrière (20) du manchon de boîtier (14),
**caractérisé :**
**en ce que** l'unité de capteur (12), le support (16) et l'élément de liaison (24) sont assemblés conjointement avec un manchon de blindage (26) entourant le support (16) en vue du blindage par rapport à un rayonnement électromagnétique en un sous-ensemble de forme stable (28),
**en ce que** le sous-ensemble (28) est ensuite introduit dans le manchon de boîtier (14) et y est logé et fixé, et
**en ce que** le manchon de blindage (30) est relié de manière électrique au support (16).

2. Procédé selon la revendication 1,
**caractérisé :**
**en ce que** le sous-ensemble (28) est introduit dans le manchon de boîtier (14) du côté de l'extrémité de mesure (22).

3. Procédé selon la revendication 1,
**caractérisé :**
**en ce que** le sous-ensemble (28) est introduit dans le manchon de boîtier (14) du côté de l'extrémité arrière (20).

4. Procédé selon une des revendications 1 à 3,
**caractérisé :**
**en ce que** le sous-ensemble (28) est introduit de manière étanche dans le manchon de boîtier (14).

5. Procédé selon une des revendications 1 à 4,
**caractérisé :**
**en ce qu'**on utilise un manchon de blindage (30) cylindrique et un manchon de boîtier (14) cylindrique.

6. Procédé selon une des revendications 1 à 5,
**caractérisé :**
**en ce que** le support (16) est constitué sous la forme d'une carte de circuit imprimé (32) et est amené en engagement aligné avec l'unité de capteur (12), et
**en ce que** la carte de circuit imprimé (32) est reliée de manière électrique à l'unité de capteur (12).

7. Procédé selon une des revendications 1 à 6,
**caractérisé :**
**en ce que** le manchon de blindage (26) vient en butée de manière définie contre l'unité de capteur (12) en entourant le support (16).

8. Procédé selon une des revendications 1 à 7,
**caractérisé :**
**en ce que** le manchon de blindage (26) défini de manière coaxiale vient en alignement avec l'unité de capteur (12) et avec le manchon de boîtier (14).

9. Procédé selon une des revendications 1 à 8,
**caractérisé :**
**en ce qu'**au niveau du sous-ensemble (28), une coulée de moulage est effectuée dans l'élément de liaison (24).

10. Procédé selon une des revendications 1 à 9,
**caractérisé :**
**en ce qu'**on utilise un élément de liaison (24) avec au moins une sortie de câble.

11. Procédé selon une des revendications 1 à 9,
**caractérisé :**
**en ce qu'**on utilise un élément de liaison (24) avec au moins une sortie de connecteur.

12. Procédé selon une des revendications 1 à 11,
**caractérisé :**
**en ce que** l'élément de liaison (24) est mis en place sur une région terminale du manchon de blindage (30), dans un alignement défini avec le support (16).

13. Procédé selon une des revendications 1 à 12,
**caractérisé :**
**en ce que** l'élément de liaison (24) défini de manière coaxiale est aligné par rapport au manchon de boîtier (14) et au manchon de blindage (26).

14. Procédé selon une des revendications 1 à 13,
**caractérisé :**
**en ce que** la précoulée de moulage est effectuée avec un matériau transparent ou semi-transparent après durcissement.

15. Procédé selon une des revendications 1 à 14,
**caractérisé :**
**en ce qu'**on procède à une coulée de moulage des zones situées entre le support (16) et le manchon de blindage (26) ainsi qu'entre le manchon de blindage (26) et le manchon de boîtier (14).

16. Procédé selon une des revendications 1 à 14,
**caractérisé :**
**en ce qu'**on utilise un élément de liaison (24) comportant une collerette allongée (42), qui est glissée sur le manchon de blindage (30) et vient en butée sur l'unité de capteur (12).

17. Procédé selon la revendication 16,
**caractérisé :**
**en ce que** la collerette allongée (42) est alignée de manière coaxiale avec le manchon de boîtier (14) et le manchon de blindage (26).

18. Procédé selon une des revendications 16 ou 17,
**caractérisé :**
**en ce que** la collerette allongée (42) forme avec le logement de transducteur (64) un élément de chevauchement et/ou une butée définie.

19. Procédé selon une des revendications 16 à 18,
**caractérisé :**
**en ce que** le sous-ensemble (28) est maintenu par rapport au manchon de boîtier (14) par une coulée de moulage et/ou par une pulvérisation de matière thermodurcissable et/ou au moyen d'une liaison par collage.

20. Procédé selon une des revendications 1 à 19,
**caractérisé :**
**en ce que**, avant d'être reliée au circuit (18) sur la carte de circuit imprimé (32), l'unité de capteur (12) est insérée dans un boîtier de blindage (36) en forme de gobelet.

21. Procédé selon la revendication 20,
**caractérisé :**
**en ce que** des languettes de contact (38) prévues sur le boîtier de blindage (36) sont soudées à la carte de circuit imprimé (32).

22. Procédé selon une des revendications 1 à 21,
**caractérisé :**
**en ce que** la coulée est effectuée par au moins une ouverture (40) dans l'élément de liaison (24).

23. Sous-ensemble pour un dispositif de commutation destiné à être monté dans un manchon de boîtier,
avec une unité de capteur (12) comprenant un capteur (13) pour la détection d'un signal de mesure,
avec un circuit électronique (18) disposé sur un support (16), le support (16) étant relié à l'unité de capteur (12) au niveau d'une extrémité de mesure en constituant un élément de forme stable et le circuit (18) étant relié de manière électrique à l'unité de capteur (12),
**caractérisé par** :
un manchon de blindage (26), relié de manière électrique au support (16) et entourant ce dernier en vue du blindage par rapport à un rayonnement électromagnétique, et relié - en constituant un élément de forme stable - à l'unité de capteur (12) et/ou au support (16), et
un élément de liaison (24), destiné au raccordement du circuit (18) à des appareils externes et monté sur le support (16) et/ou sur le manchon de blindage (26).

24. Sous-ensemble selon la revendication 23,
**caractérisé :**
**en ce que** le capteur (13) est constitué sous la forme d'un capteur de température, de pression et/ou de gaz, notamment de type inductif, optique ou capacitif.

25. Sous-ensemble selon une des revendications 23 à 24,
**caractérisé :**
**en ce que** l'unité de capteur (12) est munie d'un boîtier de blindage (36) et/ou d'une unité assurant un centrage mécanique du manchon de blindage (26).

26. Sous-ensemble selon une des revendications 23 à 25,
**caractérisé :**
**en ce que** le support (16) est constitué sous la forme d'une carte de circuit imprimé (32).

27. Sous-ensemble selon une des revendications 23 à 26,
**caractérisé :**
**en ce que** l'élément de liaison (24) comprend une collerette allongée (42), qui vient en butée sur l'unité de capteur (12).

28. Sous-ensemble selon une des revendications 23 à 27,
**caractérisé :**
**en ce que** les espaces entre le support (16) et le manchon de blindage (26) reçoivent une coulée de moulage et/ou la pulvérisation d'un matériau isolant.

29. Sous-ensemble selon une des revendications 23 à 28,
**caractérisé :**
**en ce que** l'unité de capteur (12) comprend un logement de transducteur (64), avec une disposition axiale du transducteur de mesure (13) ou avec une disposition angulairement inclinée du transducteur de mesure (13).

30. Sous-ensemble selon une des revendications 23 à 29,
**caractérisé :**
**en ce que** la terminaison d'extrémité (24), pour les divers types de câbles (46, 48) et pour les divers types de connecteurs (56), est constituée sous forme de modules, notamment interchangeables.

## Revendications (Revendications pour l'(les) Etat(s) contractant(s) suivant(s): FR, DE, GB)

1. Procédé de fabrication d'un dispositif de commutation,
avec une unité de capteur (12), qui est disposée au niveau d'une extrémité de mesure (22) d'un manchon de boîtier (14) et reliée à un circuit électronique (18), lui-même disposé sur un support (16) logé dans le manchon de boîtier (14), et avec un élément de liaison (24) disposé au niveau d'une extrémité arrière (20) du manchon de boîtier (14),
**caractérisé :**
**en ce que** l'unité de capteur (12), le support (16) et l'élément de liaison (24) sont assemblés conjointement avec un manchon de blindage (26) entourant le support (16) en vue du blindage par rapport à un rayonnement électromagnétique en un sous-ensemble de forme stable (28),
**en ce que** le sous-ensemble (28) est ensuite introduit dans le manchon de boîtier (14) et y est logé et fixé,
**en ce que** le manchon de blindage (30) est relié de manière électrique au support (16), et
**en ce qu'**on utilise un élément de liaison (24) comportant une collerette allongée (42), qui est glissée sur le manchon de blindage (30) et vient en butée sur l'unité de capteur (12).

2. Procédé selon la revendication 1,
**caractérisé :**
**en ce que** le sous-ensemble (28) est introduit dans le manchon de boîtier (14) du côté de l'extrémité de mesure (22).

3. Procédé selon la revendication 1,
**caractérisé :**
**en ce que** le sous-ensemble (28) est introduit dans le manchon de boîtier (14) du côté de l'extrémité arrière (20).

4. Procédé selon une des revendications 1 à 3,
**caractérisé :**
**en ce que** le sous-ensemble (28) est introduit de manière étanche dans le manchon de boîtier (14).

5. Procédé selon une des revendications 1 à 4,
**caractérisé :**
**en ce qu'**on utilise un manchon de blindage (30) cylindrique et un manchon de boîtier (14) cylindrique.

6. Procédé selon une des revendications 1 à 5,
**caractérisé :**
**en ce que** le support (16) est constitué sous la forme d'une carte de circuit imprimé (32) et est amené en engagement aligné avec l'unité de capteur (12), et
**en ce que** la carte de circuit imprimé (32) est reliée de manière électrique à l'unité de capteur (12).

7. Procédé selon une des revendications 1 à 6,
**caractérisé :**
**en ce que** le manchon de blindage (26) vient en butée de manière définie contre l'unité de capteur (12) en entourant le support (16).

8. Procédé selon une des revendications 1 à 7,
**caractérisé :**
**en ce que** le manchon de blindage (26) défini de manière coaxiale vient en alignement avec l'unité de capteur (12) et avec le manchon de boîtier (14).

9. Procédé selon une des revendications 1 à 8,
**caractérisé :**
**en ce qu'**au niveau du sous-ensemble (28), une coulée de moulage est effectuée dans l'élément de liaison (24).

10. Procédé selon une des revendications 1 à 9,
**caractérisé :**
**en ce qu'**on utilise un élément de liaison (24) avec au moins une sortie de câble.

11. Procédé selon une des revendications 1 à 9,
**caractérisé :**
**en ce qu'**on utilise un élément de liaison (24) avec au moins une sortie de connecteur.

12. Procédé selon une des revendications 1 à 11,
**caractérisé :**
**en ce que** l'élément de liaison (24) est mis en place sur une région terminale du manchon de blindage (30), dans un alignement défini avec le support (16).

13. Procédé selon une des revendications 1 à 12,
**caractérisé :**
**en ce que** l'élément de liaison (24) défini de manière coaxiale est aligné par rapport au manchon de boîtier (14) et au manchon de blindage (26).

14. Procédé selon une des revendications 1 à 13,
**caractérisé :**
**en ce que** la précoulée de moulage est effectuée avec un matériau transparent ou semi-transparent après durcissement.

15. Procédé selon une des revendications 1 à 14,
**caractérisé :**
**en ce qu'**on procède à une coulée de moulage des zones situées entre le support (16) et le manchon de blindage (26) ainsi qu'entre le manchon de blindage (26) et le manchon de boîtier (14).

16. Procédé selon une des revendications 1 à 14,
**caractérisé :**
**en ce que** la collerette allongée (42) est alignée de manière coaxiale avec le manchon de boîtier (14) et le manchon de blindage (26).

17. Procédé selon une des revendications 1 ou 16,
**caractérisé :**
**en ce que** la collerette allongée (42) forme avec le logement de transducteur (64) un élément de chevauchement et/ou une butée définie.

18. Procédé selon une des revendications 1 à 17,
**caractérisé :**
**en ce que** le sous-ensemble (28) est maintenu par rapport au manchon de boîtier (14) par une coulée de moulage et/ou par une pulvérisation de matière thermodurcissable et/ou au moyen d'une liaison par collage.

19. Procédé selon une des revendications 1 à 18,
**caractérisé :**
**en ce que**, avant d'être reliée au circuit (18) sur la carte de circuit imprimé (32), l'unité de capteur (12) est insérée dans un boîtier de blindage (36) en forme de gobelet.

20. Procédé selon la revendication 19,
**caractérisé :**
**en ce que** des languettes de contact (38) prévues sur le boîtier de blindage (36) sont soudées à la carte de circuit imprimé (32).

21. Procédé selon une des revendications 1 à 20,
**caractérisé :**
**en ce que** la coulée est effectuée par au moins une ouverture (40) dans l'élément de liaison (24).

22. Sous-ensemble pour un dispositif de commutation destiné à être monté dans un manchon de boîtier,
avec une unité de capteur (12) comprenant un capteur (13) pour la détection d'un signal de mesure,
avec un circuit électronique (18) disposé sur un support (16), le support (16) étant relié à l'unité de capteur (12) au niveau d'une extrémité de mesure en constituant un élément de forme stable,, et le circuit (18) étant relié de manière électrique à l'unité de capteur (12),
**caractérisé par** :
un manchon de blindage (26), relié de manière électrique au support (16) et entourant ce dernier en vue du blindage par rapport à un rayonnement électromagnétique, et relié - en constituant un élément de forme stable - à l'unité de capteur (12) et/ou au support (16), et
un élément de liaison (24), destiné au raccordement du circuit (18) à des appareils externes et monté sur le support (16) et/ou sur le manchon de blindage (26),
et dans lequel l'élément de liaison (24) comprend une collerette allongée (42), qui est glissée sur le manchon de blindage (30) et vient en butée sur l'unité de capteur (12).

23. Sous-ensemble selon la revendication 22,
**caractérisé :**
**en ce que** le capteur (13) est constitué sous la forme d'un capteur de température, de pression et/ou de gaz, notamment de type inductif, optique ou capacitif.

24. Sous-ensemble selon une des revendications 22 à 23,
**caractérisé :**
**en ce que** l'unité de capteur (12) est munie d'un boîtier de blindage (36) et/ou d'une unité assurant un centrage mécanique du manchon de blindage (26).

25. Sous-ensemble selon une des revendications 22 à 24,
**caractérisé :**
**en ce que** le support (16) est constitué sous la forme d'une carte de circuit imprimé (32).

26. Sous-ensemble selon une des revendications 22 à 25,
**caractérisé :**
**en ce que** l'élément de liaison (24) comprend une collerette allongée (42), qui vient en butée sur l'unité de capteur (12).

27. Sous-ensemble selon une des revendications 22 à 26,
**caractérisé :**
**en ce que** les espaces entre le support (16) et le manchon de blindage (26) reçoivent une coulée de moulage et/ou la pulvérisation d'un matériau isolant.

28. Sous-ensemble selon une des revendications 22 à 27,
**caractérisé :**
**en ce que** l'unité de capteur (12) comprend un logement de transducteur (64), avec une disposition axiale du transducteur de mesure (13) ou avec une disposition angulairement inclinée du transducteur de mesure (13).

29. Sous-ensemble selon une des revendications 22 à 28,
**caractérisé :**
**en ce que** la terminaison d'extrémité (24), pour les divers types de câbles (46, 48) et pour les divers types de connecteurs (56), est constituée sous forme de modules, notamment interchangeables.
